(19) Europäisches Patentamt
European Patent Office
Office européen des brevets

(11) **EP 1 508 173 B1**

(12) **EUROPÄISCHE PATENTSCHRIFT**

(45) Veröffentlichungstag und Bekanntmachung des Hinweises auf die Patenterteilung:
**18.10.2006 Patentblatt 2006/42**

(21) Anmeldenummer: 03730096.9

(22) Anmeldetag: **22.05.2003**

(51) Int Cl.:
*H01L 31/101* *(2006.01)*   *H01L 31/0352* *(2006.01)*
*H01L 27/146* *(2006.01)*

(86) Internationale Anmeldenummer:
**PCT/EP2003/005378**

(87) Internationale Veröffentlichungsnummer:
**WO 2003/100871 (04.12.2003 Gazette 2003/49)**

(54) **PHOTODIODE**

PHOTODIODE

PHOTODIODE

(84) Benannte Vertragsstaaten:
**DE FR GB**

(30) Priorität: **24.05.2002   DE 10223202**

(43) Veröffentlichungstag der Anmeldung:
**23.02.2005   Patentblatt 2005/08**

(73) Patentinhaber: **Thomson Licensing SAS
92100 Boulogne-Billancourt (FR)**

(72) Erfinder:
• **HEHEMANN, Ingo
47051 Duisburg (DE)**

• **KEMNA, Armin
47228 Duisburg (DE)**

(74) Vertreter: **Schoppe, Fritz
Patentanwälte
Schoppe, Zimmermann, Stöckeler & Zinkler
Postfach 246
82043 Pullach bei München (DE)**

(56) Entgegenhaltungen:
| | |
|---|---|
| **EP-A- 0 660 414** | **EP-A- 0 855 743** |
| **WO-A-03/100365** | **DE-A- 4 442 853** |
| **US-A- 4 910 570** | **US-A- 5 859 462** |
| **US-A- 5 861 655** | **US-A- 6 133 615** |

## Beschreibung

Die vorliegende Erfindung bezieht sich auf eine Photodiode und insbesondere auf schnelle Photodioden, wie sie beispielsweise bei optischen Speichern und in der optischen Nachrichtentechnik verwendet werden.

Die Anwendungen von Photodioden sind vielfältig. Photodioden werden beispielsweise in Röntgendetektoren, Kamerasensoren, Triangulationssensoren, Optokopplern, Überwachungseinrichtungen, optischen Speichern und optischen Übertragungssystemen eingesetzt. Vor allem bei den zuletzt genannten Anwendungsgebieten bedarf es Photodioden, die eine Signalverarbeitung im Mega- bis Gigahertzbereich ermöglichen.

Eine Photodiode nutzt das elektrische Feld eines pn-Überganges, um durch Licht erzeugte Ladungsträger einzufangen bzw. Elektronen/Loch-Paare zu trennen. Der dabei entstehende Photostrom setzt sich aus einem Drift- und einem Diffusionsanteil zusammen. Der Driftanteil entsteht durch Ladungsträger, die in der Raumladungszone des pn-Überganges generiert und dadurch unmittelbar über den Photostrom erfaßt werden. Der auf diese Weise erzeugte Driftanteil des Photostromes besitzt eine Bandbreite im Gigahertzbereich.

Der Diffusionsstrom entsteht durch Ladungsträger, die außerhalb der Raumladungszone erzeugt werden. Auf die Erzeugung hin diffundieren die Ladungsträger aufgrund einer fehlenden Feldeinwirkung ohne elektromotorische Kraft durch das Substrat und werden um ein von der Diffusionslänge abhängiges Zeitintervall versetzt zu ihrer Erzeugung erfaßt. Die Bandbreite dieses Diffusionsanteils beträgt deutlich weniger als die des Driftstromanteils, nämlich weniger als etwa 10 MHz.

Der prozentuale Anteil des Driftanteils am Gesamtphotostrom geht für große Wellenlängen gegen Null. Mit zunehmender Wellenlänge entspricht folglich die Bandbreite des Photostroms der Bandbreite des Diffusionsanteils. Die Sensitivität von Photodioden nimmt umgekehrt zunächst mit zunehmender Wellenlänge zu. Der Grund hierfür besteht darin, daß einerseits die Eindringtiefe von Licht mit zunehmender Wellenlänge zunimmt und andererseits die Rekombination von Ladungsträgern an der Oberfläche höher als bei tiefer erzeugten Ladungen ist. Dadurch ergibt sich der Anstieg der Empfindlichkeit bzw. Responsivität der Photodioden bei steigender Wellenlänge. Ab einer bestimmten Wellenlänge, die etwa 650 nm beträgt, fällt die Empfindlichkeit der Photodiode mit noch größeren Wellenlängen jedoch ab, da die aufgrund der noch größeren Eindringtiefe des langwelligeren Lichtes Ladungsträger in noch tieferen Regionen erzeugt werden und diese in noch tieferen Regionen erzeugten zur Raumladungszone der Photodiode hin diffundierenden Ladungsträger die Raumladungszone der Photodiode nicht mehr erreichen können, bevor sie rekombinieren.

Möglichkeiten, um dem Problem der beschränkten Bandbreite zu begegnen, bestanden bisher darin, bei Systemen, die eine Photodiode mit einer Bandbreite von mehreren Megahertz benötigten, auf diskrete Photodioden auszuweichen, die mittels kostenintensiver Sonderprozesse gefertigt wurden. Neben der Kosten für die externen Bauelemente kommt es hierdurch aber zu weiteren Kosten, die beispielsweise durch zusätzliche Gehäusepins, Bondpadflächen, flächen- und stromintensive Eingangs/Ausgangs-Schnittstellen und zusätzliche Leiterplattenfläche bedingt sind.

Eine alternative Lösung, die schnelle Photodioden ohne Prozeßmodifikation ermöglicht, wird in Cathleen Rooman et al, "Asynchronous 250-Mb/s Optical Receivers with Integrated Detector in Standard CMOS Technology for Optocopler Applications", IEEE Journal of Solid State Circuits, Bd. 35, Nr. 7, Seiten 953-958, Juli 2000, beschrieben. Zur Erzielung der Geschwindigkeitsoptimierung ohne Prozeßmodifikationen wird die Hälfte der Diodenfläche benutzt, um den Diffusionsstrom zu erfassen. Hierzu sind zusätzliche Schaltungsblöcke vorgesehen, die aus dem aus Diffusions- und Driftstromanteil bestehenden Photostrom den Diffusionsanteil herausrechnen. Der Nachteil an dieser Vorgehensweise besteht darin, daß etwa die Hälfte der Lichtleistung zur Erfassung des Diffusionsstromes aufgewendet wird. Außerdem befinden sich mehrere nicht verstärkende Bauelemente im Signalpfad, was wiederum eine erhebliche Verschlechterung der Rauscheigenschaften der Auslese bedeutet. Insbesondere in Kommunikations- und optischen Speichersystemen stellt das Rauschen einen kritischen Parameter dar, so daß die dort beschrittene Vorgehensweise in solchen Systemen nur bedingt nutzbar ist.

Weitere Photodiodenarrays mit reduzierten Störsignale und übersprechen sind aus US-A-5861655 sowie aus DE-A-4442853 bekannt.

Ein weiterer Nachteil bisheriger Photodioden, die auf Prozeßebene hergestellt wurden, besteht darin, daß dieselben, wie im vorhergehenden beschrieben, eine in Abhängigkeit von der Wellenlänge nicht konstante Sensitivitätskennlinie aufweisen. Eine Linearisierung der Empfindlichkeit bzw. Sensitivität wäre beispielsweise bei optischen Speichersystemen aus Kompatibilitätsgründen wünschenswert, bei denen aus archivierbaren Datenträgern in verschiedenen Geräten die Daten mit Lichtquellen unterschiedlicher Wellenlänge ausgelesen werden. Bisher wird eine solche Linearisierung erst auf Seite der Signalverarbeitung mittels aufwendiger Schaltungsblöcke, wie z.B. digitalen Signalprozessoren, erzielt.

Die Aufgabe der vorliegenden Erfindung besteht darin, eine Photodiode zu schaffen, die eine schnellere Auslese ermöglicht.

Diese Aufgabe wird durch eine Photodiode gemäß Anspruch 1 gelöst.

Eine erfindungsgemäße Photodiode umfaßt neben einem Halbleitersubstrat und einem photoempfindlichen Bereich in dem Halbleitersubstrat, der einen Raumladungszonenbereich zum Erzeugen eines Driftstromanteils und einen Diffusionsbereich zum Erzeugen eines Diffusionsstromanteils aufweist, eine Isolationseinrichtung in dem Halbleitersubstrat zum zumindest teilweisen Eingrenzen des Diffusionsbereichs gegenüber einem angrenzenden Umgebungsbereich des Halbleitersubstrats.

Der vorliegenden Erfindung liegt die Erkenntnis zugrunde, daß die Verringerung der Bandbreite von Photodioden durch das Verschmieren der Antwort der Photodiode durch den Diffusionsstrom dadurch gemindert werden kann, daß eine Isolationseinrichtung in dem Halbleitersubstrat vorgesehen wird, welchen den Diffusionsbereich gegenüber dem umgebenden Halbleitersubstrat eingrenzt und hierdurch einerseits die Anzahl von zum Diffusionsanteil beitragenden Ladungsträgern dadurch verringert, daß der Diffusionsbereich, in welchem die diffundierenden Ladungsträger erzeugt werden, verringert wird, und andererseits dadurch, daß in dem verkleinerten Diffusionsbereich erzeugte diffundierende Ladungsträger durch die Isolationseinrichtung "abgesaugt" werden, weshalb dieselben nicht zum Photostrom beitragen.

Gemäß der vorliegenden Erfindung ist das Halbleitersubstrat von einem ersten Leitfähigkeitstyp, der Raumladungszonenbereich durch einen Signalbereich mit einem zweiten Leitfähigkeitstyp in dem Halbleitersubstrat gebildet, und die Isolationseinrichtung durch einen Isolationsbereich eines zweiten Leitfähigkeitstyp in dem Halbleitersubstrat in einem vorbestimmten Abstand zu dem Signalbereich gebildet. In einem speziellen Ausführungsbeispiel der vorliegenden Erfindung, bei dem eine Mehrzahl von photoempfindlichen Bereichen als ein Photodiodenarray angeordnet sind, sind Isolationsbereiche derart angeordnet, daß sie jede durch einen jeweiligen photoempfindlichen Bereich gebildete Photodiode hinsichtlich ihres Diffusionsbereiches eingrenzen und jeden photoempfindlichen Bereich einer Photodiode vor von einem benachbarten Diffusionsbereich einer benachbarten Photodiode diffundierenden Ladungsträgern abschirmt. Die Isolationsbereiche in dem Halbleitersubstrat bilden selbst Raumladungszonen aus und bilden somit selbst Erfassungsdioden, die ebenfalls zur Auslese verwendet werden. Auf diese Weise wird ein Array von schnellen Photodioden mit wenig Diffusions- und hohem Driftstromanteil, die im folgenden als HF-Dioden bezeichnet werden, gebildet, welches von einem Array von langsamen Erfassungsdioden mit einem hohen Diffusionsstromanteil, die im folgenden als LF-Dioden bezeichnet werden, durchsetzt ist. Ein weiterer Vorteil besteht dabei darin, daß bei gleichzeitiger Auslese des durch die HF-Dioden gelieferten Photostroms und des durch den in den durch die Isolationsbereich gebildeten LF-Diode erzeugten Photostrom, eine Konstantmachung der Sensitivitätskennlinie der Photodiode über die Wellenlänge eintritt.

Weitere bevorzugte Ausgestaltungen der vorliegenden Erfindung gehen aus den anhängigen Patentansprüchen hervor.

Bevorzugte Ausführungsbeispiele der vorliegenden Erfindung werden nachfolgend Bezug nehmend auf die beiliegenden Zeichnungen näher erläutert. Es zeigen:

Fig. 1 in schematischer Darstellung eine Photodiode gemäß einem Ausführungsbeispiel der vorliegenden Erfindung;

Fig. 2a in schematischer Darstellung eine Erfassungsdiodenanordnung einer optischen Abtastvorrichtung gemäß einem Ausführungsbeispiel der vorliegenden Erfindung;

Fig. 2b ein Blockdiagramm des Auslese- und Steuerungsteils der optischen Abtastvorrichtung von Fig. 2a;

Fig. 3a ein exemplarisches Layout für die Diodenanordnung von Fig. 2 gemäß einem speziellen Ausführungsbeispiel der vorliegenden Erfindung;

Fig. 3b eine Schnittebene durch das Layout von Fig. 3a;

Fig. 4 ein Simulationsergebnis für den Dunkelstrom, der sich entlang der Schnittebene von Fig. 3b bei dem Layout von Fig. 3a einstellt;

Fig. 5 einen Graphen, der die Flächen- und Umfangskapazität der HF- und LF-Dioden in der Diodenanordnung von Fig. 3a in Abhängigkeit von der Diodenspannung zeigt, um den verbesserten Kapazitätsbelag von Fläche und Rand darzustellen;

Fig. 6 einen Graphen, der die Übergangskapazität einer HF-Diode der Diodenanordnung gemäß Fig. 3a in Abhängigkeit von der Diodenspannung zeigt;

Fig. 7 einen Graphen, der die Übergangskapazität einer LF-Diode der Diodenanordnung gemäß Fig. 3a in Abhängigkeit von der Diodenspannung zeigt;

Fig. 8 einen Graphen, der die spektrale Antwort der Dioden der Diodenanordnung gemäß Fig. 3a und allgemein die spektrale Antwort der durch die Raumladungszonen in Fig. 1 gebildeten Dioden zeigt;

Fig. 9      eine Ausleseschaltung zum Auslesen der HF-Dioden des Ausführungsbeispiels von Fig. 2;

Fig. 10      ein Ausführungsbeispiel für eine Verstärkerschaltung für den Verstärker von Fig. 9;

Fig. 11a      eine Ausleseschaltung der Auslese der LF-Dioden des Ausführungsbeispiels von Fig. 2; und

Fig. 11b      exemplarische Zeitverläufe von Signalen, die bei der Schaltung von Fig. 11a auftreten, zur Verdeutlichung des kaskadenhaften Auslesens der LF-Dioden.

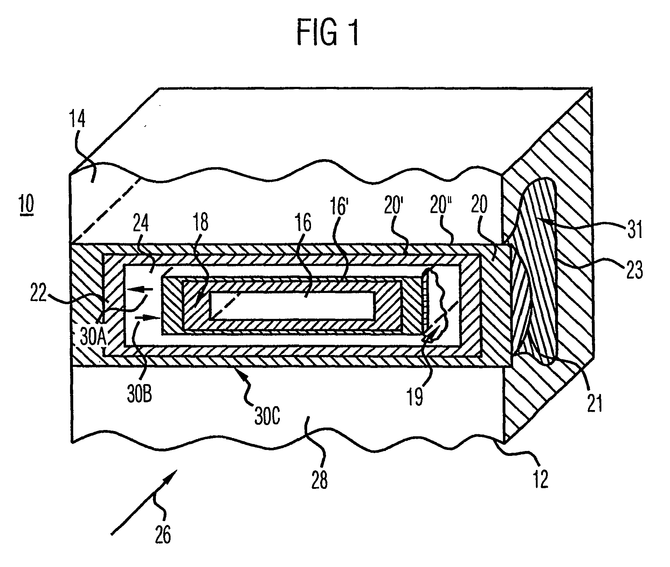

Fig. 1 zeigt ein Ausführungsbeispiel einer Photodiode, die allgemein mit 10 angezeigt ist. Die Photodiode umfaßt ein Substrat eines ersten Leitfähigkeitstyps, wie z.B. p-dotiert, welches allgemein mit 12 angezeigt ist und eine Hauptoberfläche 14 aufweist, welche in Fig. 1, die als Teilschnittraumdarstellung ausgeführt ist, frontal zu sehen ist. In dem Halbleitersubstrat 12 ist ein Signalbereich 16 eines zweiten, zu dem ersten entgegengesetzten Leitfähigkeitstyps gebildet, wie z.B. n-dotiert, wobei dessen Umfang in Fig. 1 mit 16' angezeigt ist. Der Signalbereich 16 grenzt an die Hauptoberfläche 14 an und erstreckt sich bis zu einer gewissen Tiefe in das Substrat hinein. Durch den Signalbereich 16 des zweiten Leitungstyps in dem Halbleitersubstrat 12 des ersten Leitungstyps wird ein Raumladungszonenbereich 18 gebildet, der in Fig. 1 schattiert dargestellt ist und sich entlang des Umfangs 16' des Signalbereiches 16 sowohl in den Signalbereich 16 hinein als auch von demselben in das Halbleitersubstrat 12 hinein erstreckt. In der Tieferichtung erstreckt sich die Raumladungszone 18 ebenfalls bis zu einer gewissen Tiefe, wie es durch den schraffierten Abschnitt in dem weggenommenen Abschnitt bei 19 gezeigt ist. Insbesondere erstreckt sich der Raumladungszonenbereich 18 von der Hauptoberfläche 14 weg tiefer in das Substrat 12 entlang der Grenzfläche bzw. des Umfangs 16' des Signalbereichs 16, der ja eine vorbestimmte Tiefe aufweist, und beispielsweise als n⁺-dotierte Wanne gebildet ist.
Den Signalbereich 16 umgebend ist in dem Halbleitersubstrat 12 ferner ein Isolationsbereich 20 gebildet, der ebenfalls vom zweiten Leitfähigkeitstyp, beispielsweise schwach n-dotiert bzw. n⁻-dotiert, ist, und dessen Umfang in Fig. 1 mit durchgezogenen Linien 20' und 20" gezeigt ist. Der Isolationsbereich erstreckt sich grabenförmig bis zu einer im folgenden näher erörterten Tiefe in das Substrat 12, wie es durch einen schraffierten Bereich 21 im Seitenschnitt zu sehen ist. Durch den Isolationsbereich 20 in dem Halbleitersubstrat 12 wird eine Raumladungszone 22 gebildet, die sich über den Umfang bzw. die innere Grenzfläche des Isolationsbereiches hinweg sowohl in das Halbleitersubstrat 12 als auch in den Isolationsbereich 20 erstreckt. Wie es durch den gestrichelten Bereich 23 im Seitenschnitt angezeigt ist, dehnt sich die Raumladungszone 22 von der Hauptoberfläche 14 auch in Richtung der Tiefe in das Halbleitersubstrat 12 entlang der inneren Grenzfläche 20' des Isolationsbereiches 20 aus.
Zwischen den Raumladungszonen 18 und 22 ist in Fig. 1 ein Diffusionsbereich mit dem Bezugszeichen 24 angezeigt, der sich zwischen den Raumladungszonen 18 und 22 erstreckt. Mit einem Bezugszeichen 26 ist in Fig. 1 ein Pfeil angezeigt, der eine Strahlungsrichtung von einfallendem Licht darstellen soll. Das Bezugszeichen 28 zeigt einen lateralen Umgebungsbereich des Halbleitersubstrats 12 an, der sich außerhalb des Isolationsbereiches 20 befindet und denselben umgibt. Mit dem Bezugszeichen 30a, 30b und 30c versehene Kreise sollen diffundierende Ladungsträger darstellen, welche durch das einfallende Licht 26 erzeugt worden sind.
Einfallendes Licht 26 wird an der Photodiode 10 durch Erfassen des Photostromes über einen mit dem Signalbereich 16 verbundenen Kontaktierungsleiter (nicht gezeigt) erfaßt. Der Photostrom der Photodiode 10 setzt sich aus einem Driftstromanteil und einem Diffusionsstromanteil zusammen. Der Driftstromanteil entsteht durch Ladungsträger, die in der Raumladungszone 18 des Leitfähigkeitsübergangs 16' erzeugt und aufgrund der über den Signalbereich 16 und des Halbleitersubstrats 12 angelegten Sperrspannung unmittelbar erfaßt wird. Der so erzeugte Driftstromanteil besitzt eine Bandbreite im Gigahertzbereich.
Der Diffusionsstromanteil entsteht durch die Ladungsträger, die nicht in der Raumladungszone 18 erzeugt werden und daraufhin ohne elektromotorische Kraft durch das Halbleitersubstrat 12 zur signaldetektierenden Raumladungszone 18 diffundieren. Aufgrund das Isolationsbereiches 20 bzw. der Raumladungszone 22 erreichen jedoch nicht alle erzeugten Ladungsträger die signaldetektierende Diode. Nicht alle erzeugten Ladungsträger 30a-30c tragen deshalb zu dem Diffusionsstrom der Photodiode 10 bei. Der Grund hierfür besteht zunächst darin, daß die Raumladungszone 22 den Bereich, in welchem Ladungsträger erzeugt werden, lateral in zwei Teile teilt, nämlich einen Teil, in welchem die dort erzeugten Ladungsträger zu der signaldetektierenden Diode gelangen können, und einen Teil, bei dem dies nicht geht. Der erste Teil, in welchem zu dem Diffusionsstromanteil beitragende Ladungsträger erzeugt werden können, ist durch die Raumladungszone 22 bzw. den Isolationsbereich 20 auf den Diffusionsbereich 24 eingeschränkt. Umgekehrt kann ein in dem Umgebungsbereich 28 erzeugter Ladungsträger 30c aufgrund des Isolationsbereiches 20 nicht die signalerfassende Raumladungszone 18 erreichen, da er zuvor von der dieselbe abschirmenden Raumladungszone 22 eingefangen wird. Der eigentliche Diffusionsbereich bzw. das Einzugsgebiet, in welchem Ladungsträger erzeugt und zu der signalerfassenden Raumladungszone 18 diffundieren können, würde sich folglich ohne Isolationsbereich 20 lateral weiter als die Raumladungszone 22 in den Umgebungsbereich 28 des Halbleitersubstrats 12 ausbreiten, und zwar so weit, wie es durch die Diffusionslänge der Ladungsträger in dem Halbleitersubstrat 12 bestimmt ist, d.h. die Länge, die ein Ladungsträger in dem Material des Halbleitersubstrats 12, wie z.B. Silizium, durchschnittlich oder maximal zurücklegt, bis derselbe rekombiniert.

Ein weiterer Effekt der Raumladungszone 22 besteht darin, daß er nicht nur den effektiven Einzugsbereich von diffundierenden Ladungsträgern lateral auf den Diffusionsbereich 24 einschränkt, sondern daß derselbe in dem Diffusionsbereich 24 erzeugte und in demselben diffundierende Ladungsträger 30a abfängt, welche ohne elektromotorischen Antrieb zu der Raumladungszone 22 und nicht der Raumladungszone 18 diffundieren.

Lediglich die übrigen Ladungsträger, die in dem Diffusionsbereich 24 oder in Gebieten des Halbleitersubstrats 12 unterhalb der signaldetektierenden Raumladungszone 22 durch das einfallende Licht 26 erzeugt und noch vor einer Rekombination in die Raumladungszone 18 diffundieren, tragen zum Diffusionsstromanteil und somit zum Photostrom der Photodiode 10 bei, wie z.B. der Ladungsträger 30b. Da der Diffusionsstromanteil eine geringere Bandbreite als der Driftstromanteil im Bereich von weniger als 10 MHz aufweist, wird durch die Verringerung des Diffusionsstromanteils durch Vorsehen der isolierenden Raumladungszone 20 eine Erhöhung der Auslesegeschwindigkeit bzw. Bandbreite der Photodiode 10 erzielt.

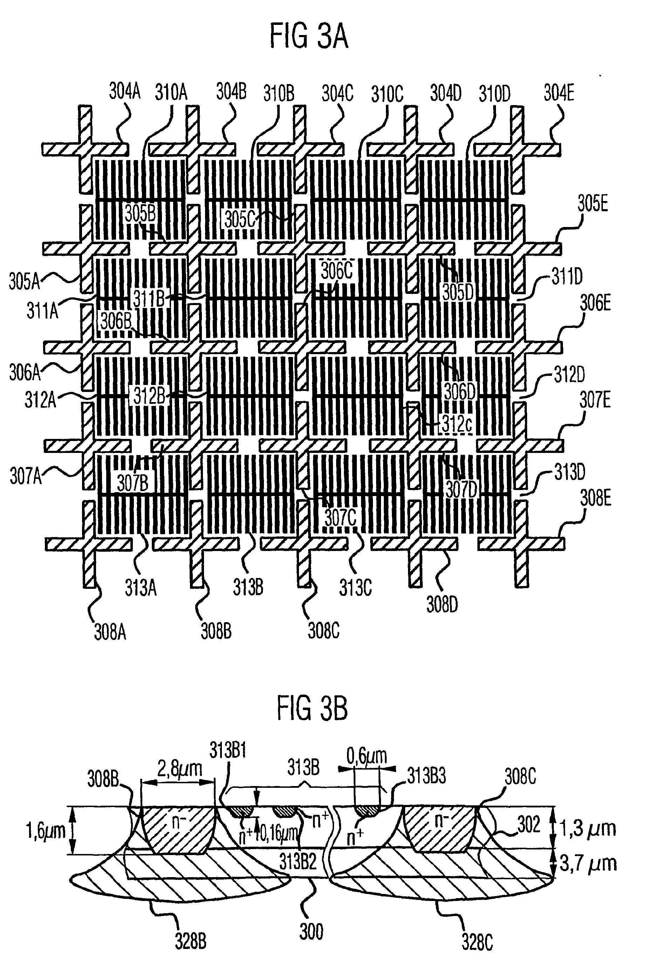

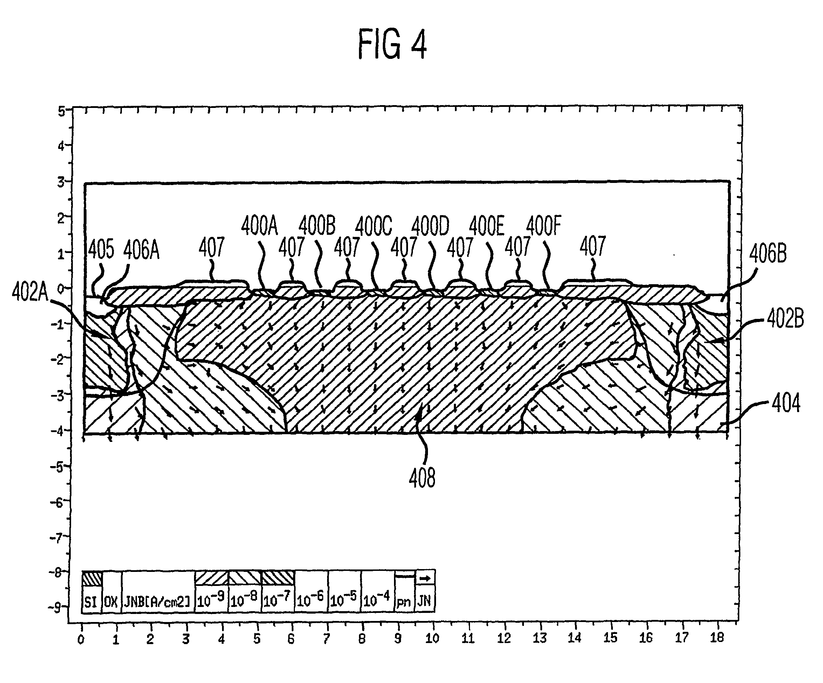

Eine vertikale Abschirmung der signaldetektierenden Raumladungszone vor tiefergelegenen, unterhalb derselben angeordneten Gebieten des Halbleitsubstrats 12 in Tieferichtung bzw. vertikal kann trotz der lediglich lateralen Strukturausrichtung des Isolationsbereiches beispielsweise durch ein Dotierungsprofil des Halbleitsubstrates 12 erzielt werden, welches eine mit einem vorbestimmten Dotierungsgradienten in Tieferichtung abnehmende Dotierungsdichte aufweist, da sich hierdurch eine Ausbauchung der Raumladungszone 22 in tiefergelegenen Regionen der Halbleitersubstrats ergibt, wie es bei 31 angedeutet ist, welche sich auch unter die signaldetektierende Raumladungszone 18 erstreckt und diese hierdurch vertikal von noch tiefergelegenen Regionen des Halbleitersubstrats isoliert bzw. vor dort erzeugten und in Richtung der signaldetektierenden Raumladungszone 18 diffundierenden Ladungsträgern abschirmt. Dieser Effekt wird näher bezugnehmend auf Fig. 3b und Fig. 4 beschrieben. Unterstützt wird die vertikale Abschirmung durch Vorsehen des Isolationsbereiches 20 mit einer schwächeren Dotierung als den Signalbereich 16, so daß die Ausdehnung der Raumladungszone 22 größer als die der Raumladungszone 18 ist.

Bezugnehmend auf Fig. 1 wird darauf hingewiesen, daß die Realisierung der Photodiode 10 ohne weiteres in Standard-CMOS-Prozessen möglich ist.

Zu dem in Fig. 1 gezeigten Layout können verschiedene Abweichungen vorgenommen werden. Beispielsweise ist es nicht notwendig, daß die isolierende Raumladungszone 22 die signalerfassende Raumladungszone 18 lateral vollständig umgibt. Unter Prozeßmodifikationen könnte andererseits der die erfassende Raumladungszone 18 isolierende Raumladungszonenbereich 22 bzw. Isolationsbereich 20 wie eine Halbschale um den signalerfassenden Raumladungsbereich 18 auch unterhalb des Signalbereiches 16 herum gebildet werden, um die signalerfassenden Raumladungszone 18 auch in vertikaler Richtung vor in tiefer gelegenen Regionen erzeugten Ladungsträgern in dem Halbleitersubstrat 12 abzuschirmen. Wie bereits erwähnt wird eine Erzielung einer vertikalen Abschirmung der signaldetektierenden Raumladungszone in einem bezugnehmend auf die Figuren 3a-11 beschrieben Ausführungsbeispiel durch wannenhafte Herstellung sowohl des Signalbereiches 16 als auch des Isolationsbereiches 20 in dem Halbleitersubstrat 12 unter Ausnutzung der Ausbauchung der abschirmenden Isolationsraumladungszone beschrieben.

Die Tiefe der Isolationswanne 20 sollte größer als die Tiefe der Signalwanne 16 sein, wie z.B. um einen Faktor von 2 bis 20. Der laterale Abstand zwischen dem die abschirmenden Raumladungszone 22 bildenden Isolationsbereich 20 und dem die signalerfassende Raumladungszone 18 bildenden Signalbereich 16 sollte so gering wie möglich sein, und kann beispielsweise lateral weniger als die Diffusionslänge von Ladungsträgern in dem Material des Halbleitersubstrats 12 betragen, d.h. der durchschnittlichen Diffusionslänge von Ladungsträgern, die dieselben vor der Rekombination durchschnittlich bei Raumtemperatur zurücklegen. Vorteilhafte Abstände des Isolationsbereiches 20 von dem Signalbereich 16 umfassen 1 $\mu$m bis 7 $\mu$m. Die Ausdehnungen der signaldetektierenden Raumladungszonen 22 sollte möglichst groß sein, um den Driftstromanteil möglichst groß einzustellen, während die Raumladungszonen 18 und 22 möglichst eng aneinanderliegen sollten, wie z.B. mit einem Abstand von weniger als 1,5 $\mu$m um die signaldetektierende Raumladungszone 18 herum oder zumindest über mehr als die Hälfte des Umgebungsbereiches derselben.

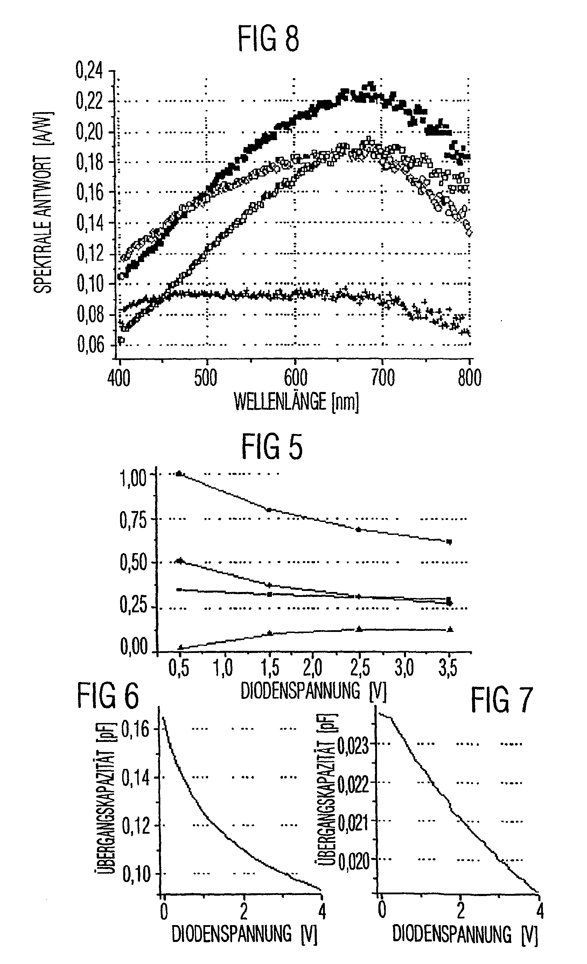

Eine Steigerung des im vorhergehenden bezugnehmend auf Fig. 1 beschriebenen Abschirmungseffektes und der Verringerung des Diffusionsstromanteils wird dadurch erzielt, daß der Isolationsbereich 20 nicht schwebend, d.h. stromlos, gehalten wird, wie es in der vorhergehenden Beschreibung von Fig. 1 angenommen wurde, sondern, daß die durch diesen Bereich in dem Halbleitersubstrat 12 gebildete Diode ebenfalls in Sperrspannung betrieben und zur Auslese eines in der Raumladungszone 22 erzeugten Photostromes verwendet wird. Um die beiden Dioden unterscheiden zu können, wird die erstere, aus der Raumladungszone 18 gebildete Diode als schnell auslesbare HF-Diode und die andere als, aus der Raumladungszone 22 gebildete Diode als LF-Diode bezeichnet. Im Fall der gleichzeitigen Auslese ist ein Kontaktierungsleiter mit dem Isolationsbereich verbunden zum Auslesen des in dem durch den Isolationsbereich 20 gebildeten Raumladungszonenbereich 22 erzeugten Photostromes und ein weiterer Kontaktierungsleiter mit dem Signalbereich 16 verbunden zur Auslese des in dem Raumladungszonenbereich 18 erzeugten Photostromes. Die positive Auswirkung der gleichzeitigen Auslese von HF- und abschirmender LF-Diode ist Fig. 8 zu entnehmen, die einen Graphen zeigt, in dem die Sensitivität in Ampere pro Watt über die Wellenlänge in Nanometern für den Fall einer HF-Photodiode mit kammartig strukturiertem n$^+$-Wannen-Signalbereich mit acht umgebenden Armen von vier kreuzförmig strukturierten HF-Dioden-n$^-$-Wannen-Isolationsbereichen für die vier verschiedenen Fälle aufgetragen ist, daß die Auslese bei einer der Dioden durchgeführt wird, während die jeweils andere Diode schwebend gelassen wird oder ausgelesen wird. Insbesondere zeigen kleine Kreise den Sensitivitätsverlauf bei der Auslese der HF-Diode bei schwebendem Isolationsbereich, kleine ausgefüllte Quadrate den Sensitivitätsverlauf bei der Auslese der LF-Diode bei schwebendem Signalbereich 16, kleine, nicht ausgefüllte Quadrate den Sensitivitätsverlauf bei der Auslese der LF-Diode bei gleichzeitiger Auslese der HF-Diode und kleine Kreuzchen den Sensitivitätsverlauf vor der Auslese der HF-Diode bei gleichzeitiger Auslese der LF-Diode an. Wie es zu erkennen ist, ist die Sensitivität bzw. die spektrale Antwort der abgeschirmten HF-Photodiode bzw. der durch die Raumladungszone 18 gebildeten Photodiode in dem Fall ohne gleichzeitige Auslese (kleine Kreise) verglichen zu dem Fall gleichzeitiger Auslese (kleine Kreuzchen) noch sehr variabel bezüglich der Wellenlänge und zeigt den in der Beschreibungseinleitung beschriebenen Signalverlauf. Die Sensitivität der Auslese der abgeschirmten Photodiode bei gleichzeitiger Auslese des Isolationsbereiches ist jedoch relativ konstant über die Wellenlänge. Dies liegt daran, daß der in diesem Fall mehr zum Photostrom beitragende Driftstromanteil bei konstanter Lichtleistung in erster Näherung konstant über die Wellenlänge ist.

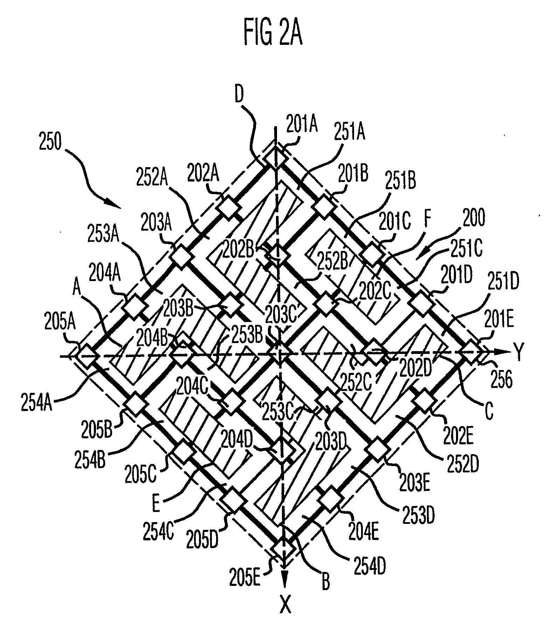

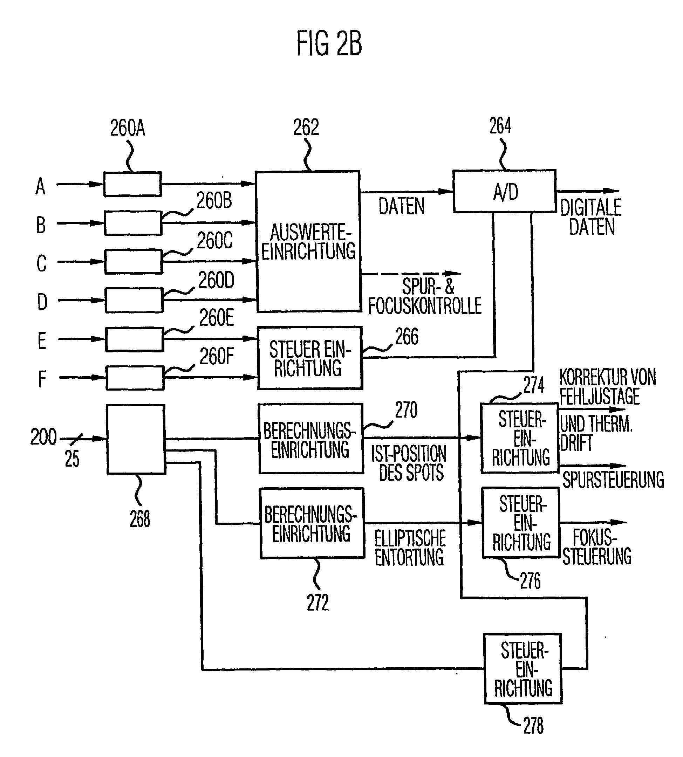

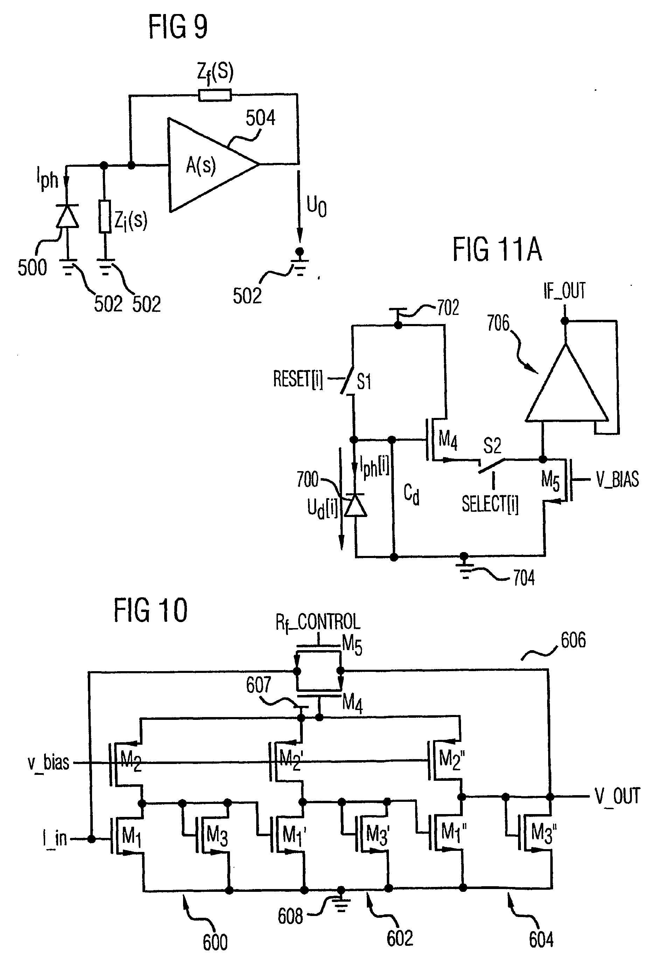

Im folgenden wird bezugnehmend auf die Figuren 2a-11 ein spezielles Ausführungsbeispiel einer optischen Abtastvorrichtung beschrieben, die dazu geeignet ist, in herkömmliche CD- und DVD-Geräte implementiert zu werden, und dabei Möglichkeiten in Hinblick auf Fokus- und Spurregelung und weitere eine Fehlausrichtung des zu erfassenden Lichtstrahls von dem Erfassungsfenster der Optikerfassungsvorrichtung verhindernde Maßnahmen ermöglicht. Obwohl die Diodenanordnung der optischen Abtastvorrichtung, die im folgenden bezugnehmend auf Fig. 2a beschrieben werden wird, auch für andere Anwendungen geeignet ist, wird sie im folgenden einer besseren Verständlichkeit halber lediglich im Rahmen ihres Einbaus in die optische Abtastvorrichtung vor dem Hintergrund der Anwendung bei CD-Geräten beschrieben. Während Fig. 2a schematisch die Diodenanordnung zeigt, zeigt Fig. 2b den Auslese- und Regelungsteil der optischen Abtastvorrichtung. Die Fig. 3a, 3b und 4 bis 8 zeigen ein Ausführungsbeispiel für eine Realisierung der Diodenanordnung in CMOS-Technologie bzw. ihre Eigenschaften, wobei Fig. 9 bis 11 Ausführungsbeispiele für mögliche Auswerteschaltungen zur Auslese der Dioden der Diodenanordnung zeigen. Bei der Beschreibung von Fig. 2a - 11b werden schnelle Photodioden von n$^-$-Wannen umgeben, die gleichzeitig als Isolationsbereiche für die Raumladungszonen der schnellen Photodioden als auch selbst als auszulesende langsame Dioden dienen. Insbesondere werden hierbei weitere vorteilhafte Ausgestaltungen möglicher Strukturen für den Isolations- und Signalbereich beschrieben. Die Isolationsbereiche werden bei diesem speziellen Ausführungsbeispiel zudem nicht nur zur Verringerung des Diffusionsstromanteils sondern ferner zur Trennung bzw. Isolation zweier benachbarter schneller Photodioden verwendet.

Die optische Abtastvorrichtung, die im folgenden Bezug nehmend auf Fig. 2-11 beschrieben wird, ist in ein CD-Laufwerk eingebaut, welches nicht gezeigt ist und dessen Aufbau grundsätzlich bekannt ist. Die im folgenden beschrieben optische Abtastvorrichtung stellt lediglich den Erfassungs- und Auslese- und Steuersignalerzeugungsteil des CD-Laufwerkes dar. Daneben umfaßt das CD-Laufwerk einen Antrieb zum Rotieren einer als optische Platte in das Laufwerk eingelegten CD, eine Laserdiode als Lichterzeugungseinrichtung, die einen Lichtstrahl erzeugt, eine Optik und Aktuatoren als Servoeinrichtung zum Einstellen eines Abstandes des Trägers zur Spur und einer lateralen Lage des Trägers relativ zur Spur abhängig von Steuersignalen zur Spur- und Fokussteuerung, wie sie wie im folgenden beschrieben aus der durch die Diodenanordnung erfaßten Intensitätsverteilung des Lichtstrahls ermittelt werden. Die Optik besteht aus optischen Bauelementen, wie z.B. einen Kollimator zum Kollimieren des Laserstrahls, einen polarisationsabhängig durchlässig oder ablenkenden Srahlteiler, ein polarisationsrichtungsveränderndes 45°-Plättchen, eine Objektiv- bzw. Sammellinse zum Bündeln des kollimierten Laserstrahls auf die auszulesende Spur der CD, auf der die auszulesenden Daten gespeichert sind, und eine Astigmatischen Linse zum Abbilden des von der Spur reflektierten und der Objektivlinse aufgefangenen Lichtstrahls auf das Diodenarray. Diodenanordnung, Laserdiode und Optik sind gemeinsam auf dem Lesekopf angebracht und weisen folglich eine fest Lage zueinander auf, die derart ausgelegt ist, daß der von der Spur modulierte und reflektierte Lichtstrahl über die Optik derart zu der Diodenanordnung geleitet wird, daß bei optimalen Betrieb der Lichtstrahl auf dem Diodenarray von Fig. 2a an einer Soll-Position angeordnet, z.B. zentriert, ist. Mehrere widrige Umstände können dafür verantwortlich sein, daß die Ist-Position die der reflektierte Laserstrahl auf dem Diodenarray von Fig. 2a einnimmt von der Soll-Position abweicht, wie z.B. eine Fehljustierung, eine thermische Drift, eine laterale oder strahlrichtungsmäßige Fehlausrichtung des Lesekopfes, wobei dieser Abweichung durch den Auslese- und Steuerungsteil von Fig. 2b durch Erzeugung geeigneter Steuersignale für die Servoeinrichtung aus der erfaßten Intensität durch die Diodenanordnung von Fig. 2a entgegengewirkt wird, wie es im folgenden näher erörtert werden wird.

Fig. 2a zeigt schematisch die Diodenanordnung der optischen Abtastvorrichtung, die zur Erfassung einer Intensitätsverteilung eines Lichtstrahls in einem Erfassungsfenster und zum Erfassen von durch den Lichtstrahl übertragenen Daten vorgesehen ist und somit den Erfassungsteil der optischen Abtastvorrichtung darstellt. Insbesondere umfaßt die Diodenanordnung von Fig. 2a ein 5x5-Array 200 von Erfassungsdioden 201a-201e, 202a-202e, 203a-203e, 204a-204e und 205a-205e, wobei die letzte Ziffer eine Zeilennummer und der Buchstabe eine Spaltennummer des 5x5-Arrays angibt. Ferner umfaßt die Diodenanordnung von Fig. 2a ein 4x4-Array 250 von Erfassungsdioden 251a-251d, 252a-252d, 253a-253d, 254a-254d. Die beiden Arrays 200 und 250 sind derart zueinander angeordnet, daß sich die Erfassungsdioden 251a-254d jeweils in den Zwischenräumen zwischen den Erfassungsdioden 201a-205e befinden. Anders ausgedrückt, sind die Erfassungsdioden 251a-254d flächenzentriert zu den Erfassungsdioden 201a-205e angeordnet und bilden zusammen eine zweidimensionale kubisch raumzentrierte Anordnung. Alle Erfassungsdioden 201a-205e und 251a-254d sind gemeinsam in demselben Erfassungsfenster 256 angeordnet, das zur Erfassung des Lichtstrahls vorgesehen ist, der von der auszulesenden Spur zurückreflektiert und von den Pits der Spur moduliert wird, so daß er die auszulesenden Daten umfaßt. Die 25 Erfassungsdioden 201a-205e sind jeweils einzeln mit einer Ausleseschaltung 268 (Fig. 2b) verbunden, die dieselben seriell ausliest, um die Ausgangssignale derselben in gemultiplexter Form auszugeben. Die Erfassungsdioden 251a-254d des Diodenarrays 250 sind zu sechs Bereichen A, B, C, D, E und F miteinander verschaltet bzw. zueinander parallel geschaltet und mit verschiedenen Ausleseschaltungen 260a, 260b, 260c, 260d, 260e und 260f (Fig. 2b) verbunden, die eine höhere Auslesegeschwindigkeit als die Auslesegeschwindigkeit aufweisen, die zur Auslese der Erfassungsdioden 201a-205e des 5x5-Arrays 200 verwendet wird. Insbesondere sind, wie in Fig. 2 angedeutet, die Erfassungsdioden 254a, 253a und 253b zu dem Bereich A, die Erfassungsdioden 254d, 253d, und 253c zu dem Bereich B, die Erfassungsdioden 252d, 251d und 252c zu dem Bereich C, die Erfassungsdioden 251a, 252a und 252b zu dem Bereich D, die Erfassungsdioden 254b und 254c zu dem Bereich E und die Erfassungsdioden 251b und 251c zu dem Bereich F zusammengefaßt.

Die Erfassungsdioden 201a-205e mit geringerer Auslesegeschwindigkeit werden als LF-Dioden bezeichnet, während die Erfassungsdioden 251a-254d mit höherer Auslesegeschwindigkeit als HF-Dioden bezeichnet werden. Die seriell ausgelesenen LF-Dioden 201a-205e werden zur Generierung von Steuersignalen für die Fokus- und Spursteuerung und für die Ansteuerung von Aktuatoren des CD-Gerätes (nicht gezeigt) verwendet, in welches die optische Abtastvorrichtung mit dem Diodenarray von Fig. 2a eingebaut ist. Die HF-Dioden 251a-254d dienen der Erfassung der durch den auf die Diodenanordnung von Fig. 2a einfallenden Lichtstrahl übertragenen Daten. Die Untergliederung derselben in die Bereiche A-F bietet, wie im folgenden beschrieben, die Möglichkeit, daß die in Fig. 2a gezeigte Diodenanordnung Signale A-D liefert, wie sie auch in herkömmlichen CD-Geräten zur Spur- und Fokusregelung verwendet werden, die für ein Fokus- und Servosignalerzeugung basierend auf einer Diodenanordnung gemäß Fig. 2 konzipiert sind. Die Bereiche E und F sind derart angeordnet, daß sie, wie es im folgenden erläutert werden wird, zur Erfassung von Crosstalkerscheinungen eingesetzt werden können.

Nachdem im vorhergehenden der Aufbau der Diodenanordnung von Fig. 2a beschrieben worden ist, wird im folgenden der Teil der optischen Abtastvorrichtung beschrieben, der für die Auslese der Dioden und die Servosignalerzeugung zuständig ist. Die in den Bereichen A-F erzeugten Ströme werden, wie oben erwähnt, jeweils durch eine Ausleseschaltung 260a, 260b, 260c, 260d, 260e und 260f ausgelesen bzw. verstärkt, wobei dieselben beispielsweise als Transimpedanzverstärker ausgebildet sind, für die ein Ausführungsbeispiel Bezug nehmend auf Fig. 9 und 10 näher beschrieben wird. Die Ausgänge der Ausleseschaltungen 260a-260d sind mit einer Auswerteschaltung 262 verbunden, die an einem Ausgang ein Datensignal an einen A/D-Wandler 264 ausgibt, an dessen Ausgang wiederum die durch den Lichtstrahl übertragenen Daten in digitaler Form ausgegeben werden. Die Auswerteschaltung 262 kann ferner ausgebildet sein, um die Eingangssignale der HF-Diodenbereiche A, B, C und D dazu zu nutzen, Steuersignale zur Spur- und Fokuskontrolle zu erzeugen und an einem oder mehreren weiteren Ausgängen auszugeben, wie es durch die gestrichelte Linie dargestellt ist. Beispielsweise ist die Auswerteeinrichtung 262 in einen entsprechenden Modus versetzbar, bei der sie zusammen mit dem Diodenarray von Fig. 2a wie eine herkömmliche Optikerfassungseinrichtung verwendet werden kann. Die Ausgänge der Ausleseschaltungen 260e und 260f sind mit einer Steuereinrichtung 266 verbunden, der an einem Ausgang ein Crosstalkdetect-Signal an einen Steuereingang des A/D-Wandlers 264 ausgibt.

Die Stromausgangssignale der Erfassungsdioden 201a-205e des Diodenarrays 200 werden, wie oben erwähnt, einer Ausleseschaltung 268 zugeführt, die dieselben seriell an zwei Berechnungseinrichtungen 270 und 272 ausgibt, wobei ein Ausführungsbeispiel für den Aufbau der Ausleseschaltung 268 Bezug nehmend auf Fig. 11a näher erörtert werden wird. Die Berechnungseinrichtung 270 berechnet die Ist-Position des Spots auf der Diodenanordnung von Fig. 2. Die Berechnungseinrichtung 272 berechnet die elliptische Entartung, d.h. das Ausmaß und die Richtung derselben, des Spots auf der Diodenanordnung von Fig. 2. Die berechneten Informationen der Berechnungseinrichtung 270 werden einer Steuereinrichtung 274 zugeführt, die abhängig von denselben Steuersignale zur Korrektur von Fehljustage und thermischer Drift und zur Spursteuerung an geeignete Aktuatoren ausgibt, die die Lage des Lesekopfes quer zur Spur und die laterale Position der Diodenanordnung von Fig. 2a verändern, wie es im folgenden näher erörtert werden wird. Die Informationen der Berechnungseinrichtung 272 werden an eine Steuereinrichtung 276 ausgegeben, die abhängig von denselben Steuersignale zur Fokussteuerung an einen entsprechenden Aktuator zur Veränderung des Abstandes zur optischen Platte erzeugt. Eine Steuereinrichtung 278 empfängt das Auslesesignal der Ausleseschaltung 268 direkt und ermittelt aus demselben ein Steuersignal zur Kompensation von Diskverkippungen und Substratdickevariationen, wie es im folgenden erörtert wird, um es an einen weiteren Steuereingang des A/D-Wandlers auszugeben.

Im folgenden wird die Funktionsweise der optischen Abtastvorrichtung mit der Diodenanordnung von Fig. 2a und dem Auslese- und Steuerteil von Fig. 2b und ihre vorteilhafte Anwendung und Funktionsweise vor dem Hintergrund des CD-Laufwerkes beschrieben, in welches dieselbe eingebaut ist.

Zur Datenauslese werden die Signale der HF-Dioden der Bereiche A, B, C und D durch die Auswerteeinrichtung 262 zusammengefaßt, d.h. ihre Ausgangssignale addiert. Der A/D-Wandler digitalisiert das zusammengefaßte Ausgangssignal der Bereiche A-D basierend auf einem Schwellenwert, das derselbe aus dem Signal crosstalkdetect von der Steuereinrichtung 266 erhält, und gibt die digitalisierten Daten als die auszulesenden, in der auszulesenden Spur gespeicherten Daten aus. Wie in der Beschreibungseinleitung erwähnt, ist es zudem möglich, die Ausgangssignale der Bereiche bzw. Regionen A-D miteinander zu verschalten, um Steuersignale für die Fokus- und Spursteuerung zu erzeugen. Unter Verwendung einer astigmatischen Linse zur Abbildung des reflektierten, Daten übertragenden Lichtstrahls auf die Diodenanordnung von Fig. 2a ist die Auswerteeinrichtung 262 in der Lage, Signale für die Abstands- bzw. Fokusregelung zu erzeugen, indem dieselbe die Ausgangssignale der Bereiche A, B, C und D von den Ausleseschaltungen 260a-d zusammenaddiert und die Summen voneinander abzieht, d.h. (A+C) - (B+D) bildet, um die elliptische Verformung bei Defokussierung zu erfassen, wobei angenommen wird, daß die Hauptachsen der astigmatischen Linse entlang der in Fig. 2a angezeigten Achsen x und y verlaufen. Ein Aktuator verstellt dann gemäß dem Fokusregelungssignal den Abstand der Objektivlinse zur optischen Platte. Ferner ist die Auswerteschaltung 262 in der Lage, Signale zur Spurregelung, d.h. zur Steuerung der radialen Bewegung des Lesekopfes über die sich drehende optische Platte, zu erzeugen, indem sie das Signal (A+D) - (C+B) auswertet, das für das sogenannte Pushpull-Muster charakteristisch ist, das durch Interferenz von Brechungsordnungen bewirkt wird, die durch die Erhöhungen erzeugt werden, die wie ein Phasengitter wirken.

Neben den Signalen der Bereiche A, B, C, D, die auch mittels des in Fig. 2 dargestellten Diodenarrays erzeugt werden, stellen nun die Bereiche E und F weitere Signale bereit. In dem vorliegenden Fall sind diese Bereiche derart angeordnet, daß sie an Stellen angeordnet sind, an denen mit Crosstalkerscheinungen aufgrund der gleichzeitigen Auslese zweier Spuren zu rechnen ist, d.h. dadurch, daß der auf die optische Platte fokussierte Auslesespot sowohl die eigentlich auszulesende als auch eine benachbarte Spur mit seinen äußeren Rändern beleuchtet. Bei einer herkömmlichen Diodenanordnung würde ein solches Crosstalkphänomen bei der Verrechung von A + B + C + D zur Datenrückgewinnung zu einem Bitfehler kommen, wenn auf der benachbarten Spur ein anderer binärer Wert (Pit oder Nicht-Pit) vorliegt als auf der tatsächlichen Spur. Durch Vorsehen der beiden zusätzlichen Bereiche E und F kann eine solche Stimulierung durch eine Crosstalkerscheinung erfaßt werden. Hierzu empfängt die Steuereinrichtung 266 die Auslesesignale von den Ausleseschaltungen 260e und 260f und erfaßt, ob das Ausgangssignal eines der beiden Bereiche E und F einen Schwellenwert überschreitet. Ist dies der Fall, stellt die Steuereinrichtung 266 die Entscheidungsschwelle für die Digitalisierung des Signals A + B + C + D durch den A/D-Wandler 264 durch das Signal crosstalkdetect entsprechend höher ein, um einen Bitfehler zu verhindern, da die Crosstalkerscheinung in dem Summensignal zu einem fälschlichen zu hohem Intensitätswert führen kann.

Während im vorhergehenden die Zusammenfassung der HF-Dioden 251a-254d zu Bereichen A-F sowie die Verwendung dieser zusammengefaßten Signale bei der Auslese einer Spur einer CD beschrieben wurde, wird im folgenden die Verwendung der Ausgangssignale der LF-Dioden 201a-205e beschrieben, wobei wiederum angenommen wird, daß der auf die Spur der CD fokussierte Spot durch eine astigmatische Linse mit den Hauptachsen X und Y auf die Diodenanordnung von Fig. 2 abgebildet wird, so daß ein zu geringer Abstand der Objektivlinse der Optik, die den Laserstrahl von der Laserdiode auf die CD fokussiert und den reflektierten Lichtstrahl zusammen mit der astigmatischen Linse auf die Diodenanordnung von Fig. 2 abbildet, zu der CD zu beispielsweise einer elliptischen Entartung entlang der Achse y und eine zu große Entfernung zu einer elliptischen Entartung entlang der Achse x führt.

Die Verwertung der durch die LF-Dioden 201a und 205e erfaßten Intensitätsverteilung des Lichtstrahls findet durch die Berechnungseinrichtungen 270, 272 und die Steuereinrichtungen 274, 276 statt. Die Berechnungseinrichtung 270 berechnet aus dem Auslesesignal der Ausleseschaltung 268, das die Intensitätsverteilung des erfaßten Lichtstrahls an dem LF-Diodenarray darstellt, eine Lage des Intensitätsschwerpunktes bzw. eine Ist-Position des Lichtstrahls auf der Diodenanordnung von Fig. 2a und gibt diese Informationen an die Steuereinrichtung 274 aus, während die Berechnungseinrichtung 272 aus denselben Informationen eine Form bzw. eine elliptische Entartung des Laserspots bestimmt und an die Steuereinrichtung 276 ausgibt. Die Bestimmungen durch die Berechnungseinrichtungen 270 und 272 können beispielsweise mittels Interpolation oder Fits bzw. Anpassungsfunktionsbestimmung über die Intensitätswerte der LF-Dioden und anschließende Auswertung, wie z.B. Extremalstellensuche im Fall der Ist-Positionsbestimmung und Analyse der Ausdehnung einer Linie gleicher Intensität im Fall der Entartungsbestimmung, ermittelt werden.

Mittels der Lageinformationen des Spots auf der Diodenanordnung von Fig. 2a erzeugt die Steuereinrichtung 274 Steuer- bzw. Servosignale zur Kompensation von Fehljustierungen innerhalb des Lesekopfes, d.h. zwischen Laserdiode, Optik und/oder Diodenanordnung, sowie thermische Driften zwischen denselben, und Steuer- bzw. Servosignale zur Spursteuerung. Die Steuereinrichtung 274 steuert beispielsweise abhängig von einer Abweichung der durch die Einrichtung 270 berechnete Ist-Position des Laserspots auf der Diodenanordnung von Fig. 2a von einer Soll-Position, die vorliegend in dem Schnittpunkt der beiden Achsen X und Y liegt, geeignete Aktuatoren, wie z.B. Piezoelemente, an, um die Diodenanordnung entsprechend lateral zu verschieben, oder andere Aktuatoren, die die relative Position des Lesekopfes quer zur auszulesenden Spur verstellen. Die Möglichkeit der lateralen Einstellung des Diodenanordnung lockert die Anforderungen an den Fertigungsprozeß eines Lesekopfes, indem die Optikerfassungsvorrichtung sowie die dazugehörige Optik und die Laserdiode eingebaut sind, und bewirkt somit eine Kostenersparnis in der Herstellung des Lesekopfes bzw. des CD-Gerätes. Hierbei sei darauf hingewiesen, daß die Matrix von LF-Dioden 200 zu diesem Zweck auch über das Gebiet der HF-Diodenmatrix 250 erweitert sein könnte, so daß ein größeres Gebiet zur elektronischen Justage entstehen würde.

Ebenso wie Fehljustierungen und thermische Driften führen, wie soeben erwähnt, auch Fehlausrichtungen des Lesekopfes quer zur auszulesenden Spur zu einer Verschiebung der Ist-Position des durch den zu erfassenden Lichtstrahl auf der Diodenanordnung von Fig. 2a erzeugten Spots. Mit dem LF-Diodenarray 200 von Fig. 2a bzw. der dadurch erfaßbaren Ist-Position des Spots ist jedoch eine Überwachung des Verlaufs dieser Ist-Position quantitativ ausrechend genau möglich, um wiederum eine vorausschauende Steuerung bzw. Servosignalerzeugung zur Spurkorrektur zu ermöglichen. Die Steuereinrichtung 276 könnte beispielsweise den für die radiale Versetzung des Lesekopfes bzw. die Verschiebung in Richtung quer zur Spur zuständige Aktuator um so stärker angesteuert werden, je mehr die Ist-Position des Spots von der Sollposition abweicht, und vorausschauend noch stärker, je schneller die Zunahme der Abweichung ist.

Diskverkippungen der optischen Platte aus einer Sollebene und Substratdickevariationen auf dem Speichermedium bzw. der optischen Platte führen zu unterschiedlichen Reflektivitäten. Der Mittelwert der durch die LF-Dioden 201a-205e erfaßten Lichtintensitäten wird deshalb durch die Steuereinrichtung 278 dafür verwendet, diese unterschiedlichen Reflektivitätsverhältnisse bei der Datenrückgewinnung dadurch zu berücksichtigen, daß die Entscheidungsschwelle für die Digitalisierung des Signals A + B + C + D bei der Digitalisierung durch den A/D-Wandler im Fall verringerter Reflektivität niedriger und andernfalls höher eingestellt wird. Dies lockert ebenfalls die Anforderungen an den Fertigungsprozeß des CD-Gerätes sowie bei der Herstellung der optischen Platten selbst und resultiert somit in einer Kostenersparnis.

Wie erwähnt führen Fokusfehler zu einer elliptischen Entartung des Laserspots auf der Erfassungsdiodenanordnung von Fig. 2. Die elliptische Entartung ist mittels der LF-Dioden 201a-205e erfaßbar und wird durch die Bestimmungseinrichtung 272 bestimmt, so daß die Steuereinrichtung 276 abhängig von der erfaßten elliptischen Entartung bzw. der Ausrichtung derselben und dem Ausmaß derselben ein Steuersignal zur Fokussteuerung bzw. ein Steuersignal an einen Aktuator zur Veränderung des Abstandes einer Objektivlinse von der CD einstellen kann.

Nachdem im vorhergehenden Bezug nehmend auf die folgenden Figuren wird eine vorteilhafte Realisierung einer Diodenanordnung von Fig. 2a beschrieben, die in CMOS-Technologie, wie z.B. einer 0,6 $\mu$m-Standard-CMOS-Technologie, implementierbar ist, und bei der die erfindungsgemäße Abschirmung schneller HF-Dioden durch aus Isolationsbereichen gebildeten Raumladungszonen bei gleichzeitiger Auslese derselben bewirkt wird. Zunächst wird Bezug nehmend auf Fig. 3a und 3b das Layout der Diodenanordnung beschrieben. Fig. 3a zeigt eine Draufsicht auf die Diodenanordnung, während Fig. 3b ein Schnittbild entlang der in Fig. 3a mit der gestrichelten Linie angezeigte Schnittebene darstellt. Die gesamte Diodenanordnung ist auf einem epitaktischen p⁻-dotiertem Silizium- (Si-) Substrat 300 gebildet. Eine p⁻-Wanne 302 erstreckt sich über das gesamte Gebiet, das durch die Diodenanordnung eingenommen wird, und ist in Fig. 3a nicht dargestellt. Die LF-Dioden sind mittels in Form eines Kreuzes strukturierter n⁻-Wannen in der p⁻-Wanne hergestellt worden, und sind mit dem Bezugszeichen 304a-308e versehen.

Die n⁻-Wannen 304a-308e erstrecken sich, wie es in Fig. 3b zu sehen ist, entlang des Querschnittes bis hinab in das epitaktische p⁻-Substrat 300. Die HF-Dioden sind durch Doppelkamm-strukturierte, quadratische n⁺-Diffusionsbereiche in der p⁻-Wanne 302 gebildet und mit dem Bezugszeichen 310a-313d versehen. In Fig. 3b ist lediglich der Schnitt durch den n⁺-Diffusionsbereich 313b gezeigt, wobei insbesondere lediglich drei Finger 313b1, 313b2 und 313b3 der Doppelkammstruktur gezeigt sind. Die kreuzstrukturierten n⁻-Wannen 304a-308e erstrecken sich mit ihren vier Armen jeweils zwischen zwei benachbarte n⁺-Diffusionsbereiche 310a-310d, derart, daß jedes Paar benachbarter n⁺-Diffusionsbereiche durch zwei sich aufeinander zu streckende und über eine Lücke beabstandete Arme benachbarter n-Wannen im wesentlichen getrennt ist. Die Kontaktierungen der n-Elektroden der einzelnen LF- und HF-Dioden kann durch geeignetes Führen von Leiterbahnen vorgesehen sein. Wie es Fig. 3b zu entnehmen ist, betragen exemplarische Abmessungen für das Layout: 1,6 $\mu$m Tiefe der n⁻Wannen, 2,8 $\mu$m Breite der vier Arme der n⁻Wannen, 0,16 $\mu$m Tiefe und 0,6 $\mu$m Breite der Finger der n⁺-Diffusionsbereiche, 3,7$\mu$m Dicke des epitaktischen Si-Substrates 300 und 1,3 $\mu$m Dicke der 1,3$\mu$m Tiefe der p⁻-Wanne 302. Die Vorzüge, die sich aus den lateralen Formen, den Querschnitten und den Dotierungen der LF- und HF-Dioden ergeben, die durch die n⁻-Wannen 304a-308e bzw. die n⁺-Diffusionsbereiche 310a-313d in der p-Wanne 302 gebildet werden, werden im folgenden Bezug nehmend auf die Fig. 4 bis 8 näher erläutert.

Ein Vorteil der kammartigen Struktur der n⁺-Diffusionsbereiche der HF-Dioden besteht darin, daß die Eindringtiefe für Wellenlängen in Silizium in dem nahen ultravioletten Bereich, d.h. 405 nm, die für zukünftige Generationen von Speichersystem relevant sein werden, etwa 200 nm beträgt, so daß die Elektronenlochpaare hauptsächlich an der Oberfläche erzeugt werden. Dies bedeutet, daß die Elektronenlochpaare wirksamer durch laterale pn-Übergänge, d.h. diejenigen Abschnitte der pn-Übergänge, bei denen sich die pn-Grenzfläche von der Oberfläche weg im wesentlichen senkrecht zur Oberfläche erstreckt, getrennt werden, wie sie entlang des Umfangs der n⁺-Diffusionsbereiche und der n⁻-Wannen vorkommen. Da durch die Kammstruktur der n⁺-Diffusionsbereiche 310a-313d das Verhältnis der Länge des Umfangs zur lateralen Fläche der n⁺-Diffusionsbereiche 310a-313d besonders groß ist, führt dies zu einer verbesserten Empfindlichkeit bzw. Antwort der n⁺-Diffusionsbereiche 310a-313d bzw. der streifenförmigen Diodenfinger 313b1-313b3 in diesem Wellenlängenbereich gegenüber kompakteren Strukturen.

Ein weiterer Vorteil der kammartigen Struktur der n⁺-Diffusionsbereiche 310a-313d besteht darin, daß dieselben eine geringe Photodiodenkapazität aufweisen. Dies ist vorteilhaft, da dieselben eine möglichst schnelle Auslese ermöglichen sollen, und da dies bei der Auslese mittels Transimpedanzverstärkern, wie sie Bezug nehmend auf Fig. 9 und 10 beschrieben werden wird, zu einer erhöhten Bandbreite bei der Auslese führt. So hängt in dem Fall der Verwendung eines Transimpedanzverstärker mit einer hohen Bandbreite von beispielsweise bis zu 250 MHz und einer hohen Transimpedanz von beispielsweise bis zu 200 kΩ zur Auslese die Bandbreite $f_{-3dB}$ des Auslesesystems aus Transimpedanzverstärker und Diode beispielsweise folgendermaßen von der Photodiodenkapazität $C_{Diode}$ ab:

$$f_{-3dB} \propto \frac{A}{2\pi R_f} \cdot \frac{1}{C_{Diode}}$$

wobei $R_f$ die Transimpedanz und A die Gleichsignalverstärkung des Transimpedanzverstärkers und $C_{Diode}$ die Photodiodenkapazität darstellt. Zur Erzielung hoher Bandbreiten, wie es für die für die Datenrückgewinnung zuständigen HF-Dioden wünschenswert ist, ist es folglich notwendig, die Grenzflächenkapazität der auszulesenden Diode so niedrig wie möglich zu halten, um die Anforderungen zu minimieren, die dem Transimpedanzverstärker aufgebürdet werden. Daß die Doppelkammstruktur der n⁺-Diffusionsbereichen 310a-313d der HF-Dioden zu einer Verringerung der Photodiodenkapazität führt, zeigt Fig. 5. In Fig. 5 ist die Flächenkapazität der HF-Dioden in Einheiten pro Flächeneinheit (angezeigt mit runden Punkten) und die Umfangs- bzw. Seitenwandkapazität derselben in Einheiten pro Längeneinheit (angezeigt mit Vierecken) gegen die Diodenspannung V über die HF-Dioden aufgetragen. Wie es zu sehen ist, verhilft die Kammstruktur den HF-Dioden zu einer kleineren Diodenkapazität aufgrund des höheren Umfang/Fläche-Verhältnisses, so daß die erzielbare Bandbreite des Auslesesystems, welches Bezug nehmend auf Fig. 9 und 10 näher beschrieben werden wird, entsprechend höher ist.

Die Vorzüge der Wannen-Struktur der LF-Dioden bestehen hauptsächlich darin, daß diese Struktur zu einer größeren vertikalen (Tiefen-) Ausdehnung der Wanne verglichen zu derjenigen der n⁺-Diffusionsbereiche führt. Zusätzlich sorgt die laterale Form der n⁻-Wannen 304a-308e als Kreuze dafür, daß jede HF-Diode beinahe vollständig durch die Arme von vier benachbarten n⁻-Wannen 304a-308e umgeben ist. Insgesamt wird hierdurch eine Art Schutzring für diese HF-Dioden sowohl in lateraler als auch, durch den tiefen Querschnitt der n⁻-Wannen, in vertikaler Richtung gebildet. Denn falls Ladungen entlang des Umfanges einer HF-Diode erzeugt werden, werden dieselben eher durch eine LF-Diode 304a-308e eingefangen als durch eine benachbarte HF-Diode, was folglich eine Übersprech-Trennung in lateraler Richtung zwischen den HF-Dioden ergibt. Diffundierende Ladungsträger in der Epitaxieschicht 300, die nicht durch die HF-Diode aufgefangen wurden, werden durch eine der benachbarten LF-Dioden eingefangen, so daß dieselben nicht zu einer anderen, benachbarten HF-Diode diffundieren können, was für die vorliegende Anmeldung als eine vertikale Übersprech-Trennung der HF-Dioden bezeichnet wird. Dies führt zu einer erhöhten Auflösung der durch die HF-Dioden erfaßten räumlichen Intensitätsverteilung.

Ein weiterer Vorteil des oben beschrieben "Absaugens" diffundierender Ladungsträger durch die LF-Dioden besteht darin, daß diese diffundierenden Ladungsträger aufgrund ihrer Diffusionszeit die Pulsform der Diodenantwort verschmieren würden, und somit zu einer langsameren Datenauslesegeschwindigkeit führen würden. Da das Auslesen der LF-Dioden, wie es im folgenden Bezug nehmend auf Fig. 11a näher erörtert werden wird und bereits im vorhergehenden kurz erwähnt wurde, bei niedrigeren Frequenzen im Bereich von kHz ausgeführt wird, hat der langsame Diffusionsstrom, der durch die LF-Dioden eingefangen wird, umgekehrt jedoch keine Auswirkung auf die Erfassung der Intensitätsverteilung des einfallenden Lichtstrahles durch die LF-Dioden, die, wie oben beschrieben, zur Steuerung der Ausrichtung des zu erfassenden Lichtstrahls mit dem Erfassungsfenster verwendet werden kann. Es wird ausdrücklich darauf hingewiesen, daß die "Absaugung" diffundierender Ladungsträger durch die LF-Dioden-Wannen 304a-308e, wie sie soeben beschrieben wurde, sowohl in lateraler Hinsicht als auch in vertikaler Hinsicht zu einer Abschirmung der signaldetektierenden Raumladungszonen der HF-Dioden 310a-313d führt. Die laterale Abschirmung wurde im vorhergehenden im Rahmen der Übersprechschutzwirkung der LF-Dioden-Wannen 304a-308e beschrieben. Die vertikale Abschirmung tritt aufgrund einer Ausbauchung der durch die LF-Dioden-Wannen 304a-308e ausgebildeten Raumladungszonen auf, die in der Seitenschnittdarstellung von Fig. 3b mit 328b und 328c für die Dioden-Bereiche 308b und 308c dargestellt sind. Die mit der Tiefe zunehmende Ausbauchung der Raumladungszonen 328b und 328c ergibt sich aufgrund eines Dotierungsprofils des Substrats 300, welches eine mit einem vorbestimmten Dotierungsgradienten abnehmende Dotierungsdichte aufweist, und geht auch aus der Simulation von Fig. 4 hervor welche im folgenden beschrieben wird. Unterstützt wird die große Ausbreitung der Raumladungszonen 328b und c noch durch die schwache Dotierung der LF-Dioden-Wannen im Vergleich zu den stark dotierten HF-Dioden und durch die im Vergleich zu den HF-Diodenbereichen 310a-313d etwa zehnfach größere Tiefenausdehnung der LF-Dioden-Wannen 304a-308e.

Das Bilden der LF-Dioden durch n⁻-Wannen anstatt durch n⁺-Diffusionsbereiche ist darin vorteilhaft, daß hierdurch ein kleinerer Kapazitätswert erzielt wird. Zur Veranschaulichung dessen sind in dem Graphen von Fig. 5 ferner die Seitenwandphotodiodenkapazität (angezeigt mit Rauten) und die Flächenphotodiodenkapazität (angezeigt mit Dreiecken) für den Fall von n⁻-Wannendioden mit ansonsten gleicher lateraler Struktur wie die den in Fig. 5 gezeigten n⁺-Diffusionsbereich-Dioden-Kapazitätswerte zugrundeliegenden Diodenstrukturen gegen die Diodenspannung V aufgetragen. Wie es zu sehen ist, ist die Kapazität einer n⁻-Wannendiode im Vergleich zu einer n⁺-Diffusion-Diode niedriger. Zudem verringert darüber hinaus die Kreuzform der n⁻-Wannen 304a-308e aufgrund des höheren Umfang/Flächen-Verhältnisses die Diodenkapazität. Die durch die Wahl der Struktur der LF-Dioden erzielte Diodenkapazitätsreduktion ergibt wiederum ein niedrigeres Signal/Rausch-Verhältnis bei der LF-Diodenauslese. So gilt in dem Fall integrativer Auslese der n⁻-Wannen-LF-Dioden, wie sie im folgenden näher Bezug nehmend auf Fig. 11a erläutert werden wird, und bei der die LF-Dioden durch Integration ausgelesen und der Photostrom an der intrinsischen Grenzflächenkapazität der Photodiode integriert wird, für das Signal/Rausch-Verhältnis eines solchen Auslesesystems die Formel:

$$S/R - \text{Verhältnis} = 20\log\left(\sqrt{\frac{I_{ph}^2 T_{int}^2}{e^-(C_{Diode}U_{Th} + I_{ph}T_{int})}}\right)$$

Hierbei ist $T_{int}$ die Integrationszeit und $U_{Th}$ die Schwellenwertspannung desjenigen Transistors, der vorgesehen ist, um bei Beginn eines Integrationszyklus die LF-Diode auf ein definiertes Potential einzustellen, $I_{ph}$ der Photostrom der Diode und $C_{Diode}$ die Photodiodenkapazität. Folglich nimmt das Signal/Rausch-Verhältnis mit abnehmender Diodenkapazität zu, was ein zusätzlicher Vorteil der kreuzstrukturierten n⁻-Wannen ist.

Mit Hilfe eines Simulationsprogrammes wurde eine Simulation der Stromdichte thermisch erzeugter Minoritätsladungsträger als Anzeichen für optische bewirkte Ladungsträger entlang einer Schnittebene durchgeführt, die bis auf die Anzahl der Finger der Doppelkamm-strukturierten n⁺-Diffusionsbereiche dem Querschnitt von Fig. 3b entspricht. Das Ergebnis dieser Simulation ist in Fig. 4 gezeigt, wobei dort die Richtung und die Länge der äquidistant angeordneten Pfeile die Richtung und den Betrag des Dunkelstroms an dem jeweiligen Ort angeben, und wobei die Zahlenskalen an der linken und der unteren Seite des Bildes Längenangaben in Mikrometern sind. Der Betrag des Dunkelstromes ist ferner durch die gestrichelte Höhenlinien bzw. Schattierung verdeutlicht. In Fig. 4 sind mehrere HF-Dioden-n⁺-Diffusionsbereiche 400a, 400b, 400c, 400d, 400e und 400f umgeben von zwei LF-Dioden-n-Wannen 402a und 402b in einer zu Simulationszwecken ohne p-Wanne versehenen epitaktischen p⁻-Substrat 404 gezeigt. Zur Kontaktierung der n⁻-Wannen 402a,402b sind an der Oberfläche 405 n⁺-dotierte Wannenkontaktbereiche 406a und 406b vorgesehen. Feldoxid ist mit 407 angezeigt und befindet sich auf der Oberfläche 405. Mit durchgezogenen Linien ist zwischen den n⁺-Bereichen 400a-400f ein sich einstellender Leitfähigkeitsübergang der HF-Dioden angezeigt. Wie es aus Fig. 4 erkennbar ist, ergibt die Simulation, daß sich die Raumladungszone fast komplett unter die HF-Diodenfinger 400a-400f ausdehnt, was die vertikale Abschirmung der letztgenannten vor diffundierenden, in tieferen Regionen generierten Ladungsträgern und damit die höher Bandbreite der HF-Dioden aufgrund des erhöhten Dirftstrom- und verringerten Diffusionsstromanteils ermöglicht. Die den Dunkelstrom repräsentierenden Pfeile, die durch die Simulation an äquidistanten Positionen berechnet worden sind, dienen als Maß für den Verlauf an Ladungsträgern, die durch Licht generiert werden. Wie es erkennbar ist, gelangt nur ein geringer Anteil der Ladungsträger, die tiefer als 2 μm erzeugt werden, zu den HF-Diodenfingern 400a-400f, so daß der Photostrom bei denselben im wesentlichen aus Driftstrom besteht, was eine Geschwindigkeitsverbesserung im Vergleich zu nicht durch umliegende LF-Dioden abgeschirmten HF-Dioden darstellt, da, wie im vorhergehenden erwähnt, tiefer generierte Ladungsträger aufgrund ihres langen Diffusionsweges einen langen Zeitversatz zwischen Generation und Detektion erzeugen. Der Grund für den geringen Diffusionsstrom besteht darin, daß die LF-Dioden 402a und 402b die meisten Minoritätsladungsträger unterhalb einer Tiefe von 2 μm unterhalb der Si/SiO₂-Oberfläche abziehen. Lediglich der mittlere Teil 408 unterhalb der HF-Dioden 400a-400f fängt Ladungsträger ein, die in tieferen Regionen erzeugt wurden. Wie es ferner zu erkennen ist, wird es wirksam unterbunden, daß Ladungsträger zu benachbarten n⁺-HF-Diodenfingern benachbarter HF-Dioden diffundieren, so daß eine gute Übersprechtrennung erzielt wird.

Aus den obigen Betrachtungen ergibt sich ein weiterer Vorteil durch die "Absaugung" des Diffusionsstromes durch die LF-Dioden, die die HF-Dioden durch ihre Kreuzstruktur umgeben. Beachtet man, daß die Eindringtiefe des Lichtes für die Wellenlänge von 405 nm, die Wellenlänge zukünftiger optischer Speichersysteme, 0,196 μm, für Licht der Wellenlänge von 650 nm, der Betriebswellenlänge von DVD-Geräten, 2,89 μm und von Licht der Wellenlänge mit 780 nm, der Betriebswellenlänge von CD-ROM-Geräten, 8,0 μm beträgt, so ist aus der Simulation von Fig. 4 zu erkennen, daß durch Bestrahlung mit Wellenlängen von 650 nm und 780 nm die erzeugten Ladungsträger nicht zu dem Photostrom der HF-Diodenfinger 400a-400f beitragen. Folglich ist bei fester Lichtleistung der Betrag an Photostrom der HF-Dioden weniger empfindlich für die jeweilige Wellenlänge des Lichts. Als ein Ergebnis hat das Vorhandensein der LF-Dioden in der oben beschriebenen n⁻-Wannenform eine linearisierenden Effekt bezüglich der spektralen Antwort der HF-Dioden. Dieser Linearisierungseffekt geht auch aus Fig. 8 hervor, die einen Graphen zeigt, in der die spektrale Antwort der LF-Dioden (angezeigt mit kleinen Quadraten) und HF-Dioden (angezeigt mit kleinen Kreuzchen) über die Wellenlänge aufgetragen ist. Beide Kurven stellen die spektrale Antwort der HF- bzw. LF-Dioden in dem Fall der gleichzeitigen Auslese dieser Dioden dar, wie es während der Betrieres der optischen Abtastvorrichtung von Fig. 2a und 2b der Fall ist. Wie es zu erkennen ist, zeigen die LF-Dioden das typische spektrale Antwortverhalten von Photodioden: da im allgemeinen die Rekombinationsrate von Ladungsträgern an der Oberfläche höher als bei tiefer generierten Ladungen ist, steigt die spektrale Antwort bzw. Empfindlichkeit bzw. Sensitivität der Dioden bei steigender Wellenlänge an. Ab einer gewissen Wellenlänge, die im vorliegenden Fall etwa 650 nm beträgt, erreichen jedoch die diffundierenden Ladungsträger aufgrund der Tatsache, daß die Eindringtiefe von Licht in das Halbleitersubstrat mit der Wellenlänge ansteigt, die Raumladungszone der LF-Dioden nicht mehr bevor sie rekombinieren. Folglich erfolgt ab 650 nm ein Abfall der Sensitivität für größere Wellenlängen. Die Kennkurve der HF-Dioden unterscheidet sich jedoch grundlegend von derjenigen der LF-Dioden. Wie es zu erkennen ist, zeigen dieselben lediglich einen leichten Anstieg von 0,008 A/W in der Region von 400 nm bis 460 nm. Von 460 nm bis 700 nm bleibt die Sensitivität der HF-Dioden nahezu konstant und fällt in dem Intervall von 700 nm bis 800 nm um lediglich 0,21 A/W ab. Beachtet man, daß die Verstärkung eines Transimpedanzverstärkers, der, wie es im vorhergehenden bereits öfter erwähnt und im folgenden näher beschrieben werden wird, zur Auslese der HF-Dioden verwendet wird, mit aktiver Rückkopplung üblicherweise Schwankungen von ± 5% aufgrund von Nichtlinearitäten der zu seinem Aufbau verwendeten Transistoren ausgesetzt ist, die zum Teil in der Triodenregion verwendet werden, kann die spektrale Antwort der HF-Dioden nahezu als linear betrachtet werden. Dies ergibt ein Auslesesystem mit nahezu konstanter Verstärkung für alle Wellenlängen. Aufgrund der rauhen Oberfläche der Fingerdiodenstruktur der HF-Dioden und der sich ergebenden schwankenden Oxiddicke unterbleibt bei den HF-Dioden zudem ein Interferenzphänomen in der Wellenlängenregion von 650 nm bis 800 nm, wie es bei den LF-Dioden der Fall ist, bei denen sich das Interferenzphänomen bei diesen Wellenlängen ein wenig auf die spektrale Antwortfunktion auswirkt. Vorteilhaft an der HF-Diodenstruktur ist, wie es Fig. 8 zu entnehmen ist, ferner, daß die HF-Dioden für Wellenlängen im nahen Ultraviolettbereich, d.h. den Wellenlängen zukünftiger optischer Speichersysteme, eine relativ bessere Sensitivität aufweisen.

Lediglich der Vollständigkeit halber sind in Fig. 6 und 7 noch zwei Graphen gezeigt, die aufgetragen über die Diodenspannung die Kapazität einer einzelnen HF-Diode (Fig. 6) und LF-Diode (Fig. 7) darstellen. Wie es zu sehen ist, reicht die absolute Kapazität der HF-Dioden von 98 Femtofarad bei 3,3 V bis 165 Femtofarad bei 0,1 V. Dies ist ein Bereich von Werten, der unter Verwendung eines Transimpedanzverstärkers zur Auslese einfach ausgelesen werden können. Die Schwankung der Kapazität ist kein Problem, da die Spannung über die Diode durch die Ausleseschaltung konstant gehalten wird. Der Absolutwert der Übergangskapazität der LF-Dioden reicht von 19,7 Femtofarad bis 22,4 Femtofarad in einem Spannungsbereich von 3,3 V bis 1 V, welches den Bereich darstellt, bei dem die Integration des Photostromes in der im folgenden zu beschreibenden Ausleseschaltung von Fig. 11a durchgeführt wird.

Nachdem im vorhergehenden Bezug nehmend auf die Fig. 3-8 ein Ausführungsbeispiel für eine Hardwarerealisierung der Diodenanordnung von Fig. 2a,2b beschrieben worden ist, wird im folgenden ein Ausführungsbeispiel für mögliche Ausleseschaltungen der LF- bzw. HF-Dioden Bezug nehmend auf die Fig. 9-11 beschrieben, wobei sich Fig. 9 und 10 zunächst auf die Auslese der HF-Dioden beziehen, während sich Fig. 11a mit der Auslese der LF-Dioden beschäftigt.

Fig. 9 zeigt schematisch die Grundkonfiguration der Auslese einer HF-Diode bzw. von zu einem HF-Diodenbereich zusammengeschlossenen bzw. parallel geschalteten HF-Dioden, wobei die auszulesende HF-Diode bzw. HF-Diodenregion mit dem Bezugszeichen 500 angezeigt ist und den Photostrom $I_{ph}$ erzeugt. Die HF-Diode ist zwischen Bezugspotential 502 und einen Eingang eines Transimpedanzverstärkers 504 geschaltet, dessen Aufbau an einem exemplarischen Ausführungsbeispiel Bezug nehmend auf Fig. 10 näher erläutert werden wird. Die Impedanz $Z_f(s)$ stellt die Impedanz des Rückkopplungszweiges des Transimpedanzverstärkers 504 dar, während $Z_i(s)$ die Quellenimpedanz darstellt. $U_0$ ist die Ausgangsspannung am Ausgang des Transimpedanzverstärkers 504. Eine Analyse der Grundkonfiguration von Fig. 9 ergibt die Übertragungsfunktion dieser Konfiguration zu

$$\frac{U_0}{I_{ph}} = \frac{A(s)Z_f(s)Z_i(s)}{Z_i(s)(A(s)-1) - Z_f(s)}$$

wobei A(s) die Verstärkung des Transimpedanzverstärkers 504 anzeigt. In dem Fall eines idealen Verstärkers mit unendlicher Verstärkung ergibt diese Gleichung $U_0 = Z_f(s) I_{ph}$, was zeigt, daß der Photostrom $I_{ph}$ mit dem Faktor $Z_f(s)$ in eine Spannung umgewandelt wird.

In dem Fall, daß eine CMOS-Technologie zur Implementierung verwendet wird, kann $Z_f(s)$ als ein Ohmscher Widerstandswert $R_f$ betrachtet werden, während $Z_i(s)$ als kapazitiver Wert betrachtet werden kann, der sich aus der Gate-Kapazität Cg eines Eingangstransistors des Transimpedanzverstärkers und der Übergangs- bzw. Grenzflächenkapazität der HF-Diode 500 $C_d$ zusammensetzt. s ist eine Variable für die Auslesefrequenz. Unter der Annahme daß der Transimpedanzverstärker 504 eine ausreichend hohe Bandbreite aufweist, d.h. A(s) = A, und unter den obigen Annahmen bzw. Betrachtungen ergibt sich die letztgenannte Formel zu

$$\frac{U_0}{I_{ph}} = \frac{A R_f}{(A-1)\left(1 - \dfrac{s(C_g + C_d)R_f}{A-1}\right)}$$

Aus dieser Gleichung ergibt sich die -3dB-Bandbreite zu

$$f_{-3dB} = \frac{1-A}{2\pi(C_g + C_d)R_f}$$

Die letzte Gleichung zeigt, daß die -3dB-Bandbreite der HF-Auslese hauptsächlich durch drei Parameter bestimmt ist: die -3dB-Bandbreite steigt mit dem Betrag der Verstärkung A, wobei A aus Stabilitätsgründen negativ sein muß. Zudem fällt die -3dB-Bandbreite mit steigendem Rückkopplungswiderstandswert oder Eingangskapazität. Ein Rückkopplungswiderstandswert von 63 kΩ und ein Spannungsverstärkungswert von 30 ergibt beispielsweise eine Bandbreite von 142 MHz.

Fig. 10 zeigt ein Ausführungsbeispiel des Transimpedanzverstärkers 504, der vorliegend ein einendiger Eingangsverstärker ist, der verglichen mit einem Standardoperationsverstärker, wie er in den meisten optischen Pickup-Einheiten verwendet wird, aufgrund der geringeren Eingangstransistoranzahl ein besseres Rauschverhalten aufweist. Der Transimpedanzverstärker von Fig. 10 umfaßt drei Verstärkungszweige 600, 602 und 604 und einen Rückkopplungsweg 606. Jeder der Verstärkungszweige 600-604 ist bis auf Parametergrößen der Bauelemente identisch aufgebaut, weshalb im folgenden der Aufbau lediglich in Hinblick auf den ersten Verstärkungszweig 600 beschrieben wird. In der ersten Verstärkungsstufe befindet sich ein pMOS-Transistor $M_2$, dessen Gate mit dem Vorspannungsanschluß $v_{bias}$ und dessen Source-Anschluß mit Versorgungsspannungspotential 606 verbunden ist. Die zweite Verstärkungsstufe besteht aus zwei nMOS-Transistoren $M_1$ und $M_3$. Der Gate-Anschluß des Transistors $M_1$ ist mit einem Eingang $I_{in}$ des Transimpedanzverstärkers verbunden. Der Drain-Anschluß des Transistors $M_2$ ist mit dem Drain-Anschluß des Transistors $M_1$ sowie mit dem Gate- und dem Drain-Anschluß des Transistors $M_3$ verbunden. Der Source-Anschluß der nMOS-Transistoren $M_1$ und $M_3$ sind mit Masse bzw. Bezugspotential 608 verbunden. Der Drain-Anschluß des Transistors $M_2$ ist ferner mit dem Gate-Anschluß des Transistors $M_1$' der darauffolgenden Verstärkungsstufe 602 verbunden. Auf ähnliche Weise ist der Drain-Anschluß des Transistors $M_2$' der zweiten Verstärkungsstufe 602 mit dem Gate-Anschluß des Transistors $M_1$" der dritten Verstärkungsstufe 604 verbunden. Der Drain-Anschluß des pMOS-Transistors $M_2$" der dritten Verstärkerstufe ist über den Rückkopplungsweg 606 mit dem Eingang $I_{in}$ verbunden. In den Rückkopplungsweg 606 ist eine Source/Drain-Strecke eines pMOS-Transistors $M_4$ und eines nMOS-Transistors $M_5$ geschaltet. Der Gate-Anschluß des pMOS-Transistors $M_4$ ist mit Masse verbunden, während der Gate-Anschluß des nMOS-Transistors $M_5$ mit einem Anschluß $R_{f\_}$control des Transimpedanzverstärkers verbunden ist. Der Drain-Anschluß des pMOS-Transistors $M_2$" der dritten Verstärkerstufe ist ferner mit einem Ausgang $V_{out}$ des Transimpedanzverstärkers verbunden, an dem die Ausgangsspannung $U_0$ (siehe Fig. 9) anliegt.

Um die Transistoren in Sättigung für größere Eingangsströme am Eingang $I_{in}$ zu halten, kann die zweite Verstärkungsstufe 602 gegenüber den anderen Verstärkungsstufen 600 und 604 bezüglich bauelementespezifischer Parameter, wie z.B. der Gatelänge, verändert sein. Da die parasitäre Kapazität eines Ohmschen Rückkopplungswiderstandswertes die Bandbreite des Systems erheblich vermindert, wurde statt dessen eine aktive Rückkopplung durch die Transistoren $M_5$ und $M_4$ gewählt. Der tatsächliche Betrag des Widerstandswertes wird durch die Spannung an dem Eingang $R_{f\_}$control über den nMOS-Transistor $M_5$ eingestellt. Der pMOS-Transistor $M_4$ dient zur Linearisierung.

Es wird darauf hingewiesen, daß sich an dem Ausgang des Transimpedanzverstärkers $V_{out}$ ein Spannungsverstärker anschließen kann, um die Ausgangsspannung $U_0$ (siehe Fig. 9) zu verstärken, um einen ausreichenden Spannungshub zu erhalten, und die Signale von beispielsweise dem CMOS-Chip zu treiben. Hierbei sollte vorteilhafterweise die Bandbreite dieses anschließenden Spannungsverstärkers derart gewählt sein, daß er die -3dB-Bandbreite der HF-Auslese, die im vorhergehenden erörtert wurde, der Transimpedanzverstärkerkonfiguration nicht beeinträchtigt.

Fig. 11a zeigt die LF-Ausleseschaltung zur Auslese der LF-Dioden. Da die Auslese im kHz-Bereich durchgeführt wird, wird ein Integrationslösungsansatz gewählt, wobei insbesondere die Sperrschichtkapazität der LF-Dioden verwendet wird, um den Photostrom zu integrieren.

Es wird zunächst darauf hingewiesen, daß in Fig. 11a nur ein Teil der Ausleseschaltung der LF-Dioden gezeigt ist, der für die Auslese einer LF-Diode zuständig ist, die im folgenden mit dem Bezugszeichen 700 versehen ist, und daß im folgenden zunächst lediglich dieser Teil beschrieben wird. Die LF-Diode 700 ist in Reihe mit einem Schalter S1 in Sperrichtung zwischen ein Versorgungspotential 702 und Masse bzw. Bezugspotential 704 geschaltet. Mit gestrichelten Linien ist in Fig. 11a die Sperrschicht- oder Übergangskapazität $C_d$ der LF-Diode 700 als ein der LF-Diode 700 parallel geschalteter Kondensator ersatzschaltbildmäßig angedeutet. Die Zwischenverbindung zwischen LF-Diode 700 und dem Schalter S1 ist mit einem Gate eines nMOS-Transistors $M_4$ verbunden, dessen Drain-Anschluß wiederum mit Versorgungspotential 704 verbunden ist. Der Source-Anschluß des Transistors $M_4$ ist über einen Schalter S2 mit einem Eingang eines Ausgangsverstärkers 706 verbunden. Zwischen den Eingang des Ausgangsverstärkers 706 und Masse 702 ist ein nMOS-Transistor $M_5$ mit seiner Source/Drain-Strecke geschaltet, während sein Gate-Anschluß mit einem Eingang v_bias verbunden ist. Die Transistoren $M_4$ und $M_5$ bilden bei geschlossenem Schalter S2 zusammen einen Sourcefolger.

Nachdem im vorhergehenden der Aufbau des Teils der Ausleseschaltung für eine LF-Diode 700 beschrieben worden ist, wird im folgenden deren Funktionsweise beschrieben. Die Spannung über die LF-Diode 700 $U_d[i]$ wird zunächst auf die Versorgungsspannung $V_{dd}$ eingestellt, indem der Schalter S1 eingeschaltet wird. Sobald der Schalter S1 offen ist, verringert sich die Spannung $U_d[i]$ über die Grenzflächenkapazität $C_d$ der LF-Diode 700 aufgrund der Entladung der Photodiodenkapazität $C_d$ durch den Photostrom. Für die Abhängigkeit zwischen Spannung $U_d$ und der Zeit gilt:

$$U_d[i] = V_{DD} - \frac{1}{C_d} \int_{t_{reset}}^{t} I_{ph}[i](\tau)d\tau$$

wobei angenommen wird, daß die Diodenkapazität $C_d$ unabhängig von $U_d[i]$ ist, $t_{reset}$ den Zeitpunkt angibt, da der Schalter S1 geöffnet wird, t den augenblicklichen Zeitpunkt angibt, und $\tau$ eine Integrationsvariable ist. Es ist ersichtlich, daß der Spannungshub mit Abnahme von $C_d$ steigt. $U_d[i]$ ist die Eingangsspannung zu dem durch den Schalter S2 geschalteten Spannungsfolger aus den Transistoren $M_4$ und $M_5$. Die am Source-Anschluß des Transistors $M_5$ des Spannungsfolgers wird durch den Ausgangsverstärker 706 verstärkt, um die ausgelesene Spannung hinauszutreiben.

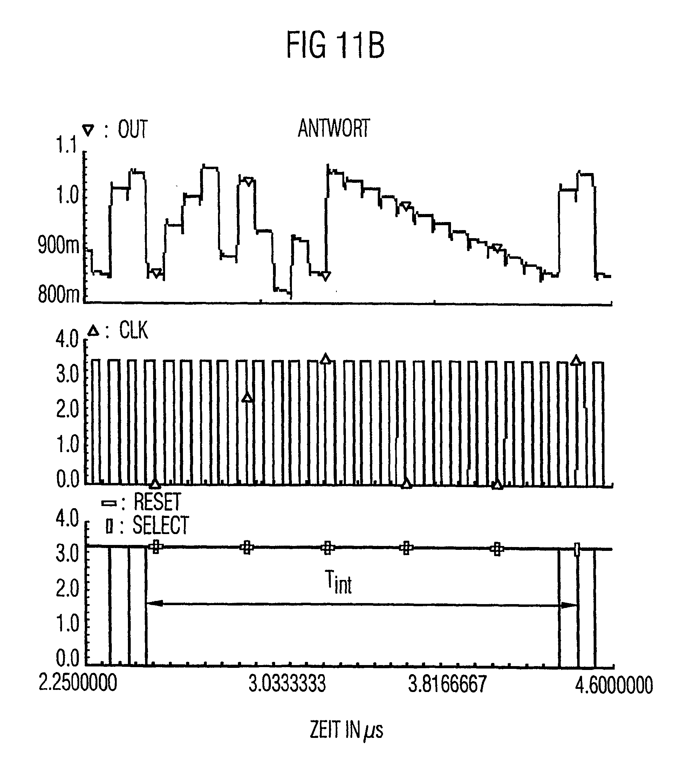

Zur Auslese aller LF-Dioden umfaßt die Ausleseschaltung für jede LF-Diode einen Schalter S1, einen Schalter S2 und einen Transistor $M_4$. Der Schalter S1 und S2 werden durch die Signale reset(i) und select[i] gesteuert. Das Zeitablaufschema für die Signale select und reset ist derart, daß von einem Eingangstakt 25 regulär phasenverschobene Pulse erzeugt werden. Der i-te Puls wird verwendet, um die Diodenspannung der i-ten LF-Photodiode zu dem Ausgangsverstärker 706 für die Länge einer Eingangtaktperiode zu leiten. Der (i+1)-te Puls wird verwendet, um die i-te LF-Photodiode zurückzusetzen. An jede LF-Photodiode des 5x5-LF-Diodenarrays werden folglich kaskadenartig Signale reset und select angelegt, die an jeder 25-ten Taktperiode einen Puls aufweisen, wobei für jede LF-Diode der Puls des reset-Signals unmittelbar auf den Puls des select-Signals folgt. Zwischen dem Rücksetzen jeder LF-Diode und dem Zeitpunkt ihres Auslesens vergehen folglich 23 Taktperioden, wobei während der Auslese bzw. der gemultiplexten Weiterleitung der augenblickliche Photostrome zu dem gespeicherten hinzugefügt wird. Die reset- bzw. select-Signale aller 25 LF-Dioden sind jeweils zueinander um eine Taktperiode versetzt, so daß seriell bzw. kaskadenartig alle 25 LF-Dioden ausgelesen werden. Der Ausgangsverstärker bzw. Ausgangsbuffer ist vorzugsweise so entworfen, daß seine Einschwingzeitdauer kürzer als die halbe Taktperiode ist. Die Taktrate kann beispielsweise 25 MHz betragen. In diesem Fall könnte die fallende Taktflanke verwendet werden, um das Ausgangssignal des Spannungsfolgers abzutasten. Zur Verdeutlichung des Ausleseschemas sind in Fig. 11b in drei untereinander angeordneten Graphen von oben nach unten beispiele für zeitliche Verläufe des Ausgangssignales if_out des Verstärkers 706, eines Takts clk für die Kaskadenmultiplexsteuerung und, in dem untersten Graphen, die reset und select für eine LF-Diode gezeigt.

Durch diesen Multiplex-Auslesebetrieb der LF-Dioden ist gewährleistet, daß für alle LF-Dioden lediglich ein Ausgangsbuffer 706 sowie lediglich ein Pin bzw. nur eine Anschlußfläche bei Implementierung der Optikerfassungsvorrichtung von Fig. 3-11 als integrierte Schaltung erforderlich ist.

Bezugnehmend auf die vorhergehende Beschreibung wird darauf hingewiesen, daß die beschriebenen Leitfähigkeitstypen, d.h. n-leitend und p-leitend, auch umgedreht werden könnten, und daß ferner auch andere Anordnungen der LF-Dioden als Array möglich sind.

Bezug nehmend auf die vorhergehende Beschreibung von Fig. 2-11 wird darauf hingewiesen, daß die Diodenanordnung von Fig. 2a mit einer oder mehreren oder allen der Einrichtungen von Fig. 2a zu einer Optikerfassungseinrichtung in Form von beispielsweise einem Chip integriert sein kann.

Vorliegend wurden folglich Ausführungsbeispiele für signaldetektierende Dioden bestehend aus Gebieten mit vorbestimmter Ausdehnung der Raumladungszone geliefert, bei denen durch entsprechendes Layout der Diode und unter Nutzung von anderen isolierenden Gebieten die Diode mit einer weiteren Raumladungszone abgeschirmt wird, wodurch bewirkt wird, daß nur wenig diffundierende Ladungsträger zu signaldetektierenden Diode gelangen. Der durch diese Diode generierte Photostrom besteht folglich nur zu einem geringen Teil aus Diffusionsstrom und besitzt somit eine entsprechend hohe Bandbreite. Zudem sind die beschriebenen schnellen Photodioden und Diodenanordnungen im Standard-CMOS-Prozeß fertigbar und ermöglichen dabei dennoch keine Signalerfassung mit hoher Bandbreite. Dies ermöglicht eine Integration in einem SOC-(System-on-Chip = System auf Chip) System, was erhebliche Kostenersparnisse bietet. Des weiteren können zur Auslese bewerte Schaltungen bzw. deren Optimierungen genutzt werden, so daß in dieser Hinsicht keine Neuentwicklungen nötig sind. Außerdem werden keine zusätzlichen Schaltungsblöcke im Signalpfad benötigt, die eine Verschlechterung der Signalqualität zur Folge hätten. Zudem weisen die beschriebenen Photodioden mit gleichzeitiger Auslese des isolierenden Raumladungszonenbereiches eine Linearität der Diodenkennlinie auf, was bei Anwendung in optischen Speichern ausgenutzt werden kann, um als einheitliches Auslesesystem verwendet zu werden.

**Patentansprüche**

1. Photodiode mit folgenden Merkmalen:

   einem Halbleitersubstrat (12);
   einem photoempfindlichen Bereich (18; 24) in dem Substrat, wobei der photoempfindliche Bereich einen Raumladungszonenbereich (18) zum Erzeugen eines Driftstromanteils und einen Diffusionsbereich (24) zum Erzeugen eines Diffusionsstromanteils aufweist; und
   einer Isolationseinrichtung (20) in dem Halbleitersubstrat (12) zum zumindest teilweisen Eingrenzen des Diffusionsbereichs (24) von einem angrenzenden Umgebungsbereich (28) des Halbleitersubstrats (12),

   wobei das Halbleitersubstrat (12) von einem ersten Leitungstyp ist, und der Raumladungszonenbereich (18) durch einen Signalbereich (16) mit einem zweiten Leitfähigkeitstyp in dem Halbleitersubstrat gebildet wird, der zu dem ersten Leitfähigkeitstyp unterschiedlich ist,
   wobei die Isolationseinrichtung durch einen Isolationsbereich (20) des zweiten Leitfähigkeitstyps in dem Halbleitersubstrat (12) in einem vorbestimmten Abstand zu dem Signalbereich (16) gebildet ist, und wobei das Halbeitersubstrat (12) ein Dotierungsprofil aufweist, welches eine in Tieferichtung abnehmende Dotierungsdichte aufweist, derart, daß sich eine Ausbauchung einer Raumladungszone des Isolationsbereiches (20) in tiefergelegenere Regionen des Halbleitersubstrats (12) ergibt, die sich auch unter den photoempfindlichen Bereich (18; 24) erstreckt und diesen hierdurch vertikal von noch tiefer gelegenen Regionen des Halbleitersubstrates (12) isoliert bzw. vor dort erzeugten und in Richtung des photoempfindlichen Bereiches (18; 24) diffundierenden Ladungsträger abschirmt.

2. Photodiode gemäß Anspruch 1, bei der der Signalbereich (16) eine Kammstruktur aufweist (310a-313d).

3. Photodiode gemäß Anspruch 1 oder 2, bei der der vorbestimmte Abstand kleiner als die Diffusionslänge von freien Ladungsträgern in dem Halbleitersubstrat (12) ist.

4. Photodiode gemäß einem der Ansprüche 1 bis 3, bei dem der vorbestimmte Abstand in einem Bereich von $1\mu$m bis $7\mu$m liegt.

5. Photodiode gemäß einem der Ansprüche 1-4, bei der sich der Isolationsbereich (20) bis zu einer vorbestimmten Tiefe in das Substrat (12) erstreckt, die um ein vorbestimmtes Vielfaches größer ist als die sich von der Hauptoberfläche (14) des Substrats (12) erstreckende Tiefe eines den Raumladungszonenbereich (18) bildenden Signalbereichs (16) ist.

6. Photodiode gemäß Anspruch 5, bei der das vorbestimmte Vielfache 2 bis 10 beträgt.

7. Photodiode gemäß einem der Ansprüche 1-6, bei dem der Isolationsbereich (20) mehrere Arme (304a-308e) aufweist, die sternförmig voneinander weisend gebildet sind, wobei sich jeder Arm zwischen den photoempfindlichen Bereich und weitere benachbarte photoempfindliche Bereiche, die zusammen mit dem photoempfindlichen Bereich Teil eines Photodiodenarrays (250) sind, erstrecken.

8. Photodiode gemäß Anspruch 7, bei der die Isolationseinrichtung weitere Isolationsbereiche (304a-308e) aufweist, die zusammen ebenfalls ein Array (200) bilden, wobei die Isolationsbereiche (304a-308e) und photoempfindlichen Bereiche derart angeordnet sind, daß die photoempfindlichen Bereiche einzeln in durch die Arme der Isolationsbereiche (304a-308e) gebildeten Zwischenräumen gebildet sind.

9. Photodiode gemäß einem der Ansprüche 1-8, die einen Kontaktierungsleiter aufweist, der mit dem Isolationsbereich (20) verbunden ist, zum Auslesen eines in einem durch den Isolationsbereich (20) gebildeten Raumladungszonenbereich (22) erzeugten Photostromes.

**Claims**

1. A photodiode, comprising:

   a semiconductor substrate (12);
   a photosensitive region (18; 24) in the substrate, the photosensitive region having a space charge zone region (18) for generating a drift current portion and a diffusion region (24) for generating a diffusion current portion; and
   an insulation means (20) in the semiconductor substrate (12) for at least partially confining the diffusion region (24) from an adjacent surrounding region (28) of the semiconductor substrate (12),

   wherein the semiconductor substrate (12) is of a first conduction type, and the space charge zone region (18) is formed by a signal region (16) with a second connectivity type in the semiconductor substrate, which is different from the first conductivity type,
   wherein the insulation means is formed by an insulation region (20) of the second conductivity type in the semiconductor substrate (12) at a predetermined spacing to the signal region, and wherein the semiconductor substrate (12) comprises a doping profile having a doping density decreasing in depth direction, such that a bulging of a space charge zone of the insulation region (20) in lower regions of the semiconductor substrate results (12), which also extends below the photosensitive region (18; 24) and thereby insulates the same vertically from lower regions of the semiconductor substrate (12) or shields the same, respectively, from charge carriers generated there and diffusing in the direction of the photosensitive region (18; 24).

2. The photodiode of claim 1, wherein the signal region (16) comprises a comb structure (310a-313d).

3. The photodiode of claim 1 or 2, wherein the predetermined spacing is smaller than the diffusion length of free charge carriers in the semiconductor substrate (12).

4. The photodiode of one of claims 1 to 3, wherein the predetermined spacing ranges from 1 $\mu$m to 7 $\mu$m.

5. The photodiode of one of claims 1 to 4, wherein the insulation region extends up to a predetermined depth into the substrate (12), which is greater than the depth extending from the main surface (14) of the substrate (12) of a signal region (16) forming the space charge zone region (18) by a predetermined multiple.

6. The photodiode of claim 5, wherein the predetermined multiple is 2 to 10.

7. The photodiode of one of claims 1 to 6, wherein the insulation region (20) comprises several arms (304a - 308e) formed facing away from each other in star-shaped manner, each arm extending between the photosensitive region and further adjacent photosensitive regions being part of a photodiode array (250) together with the photosensitive region.

8. The photodiode of claim 7, wherein the insulator comprises further insulation regions (304a-308e) also forming an array (200) together, the insulation regions (304a-308e) and photosensitive regions being arranged such that the photosensitive regions are individually formed in gaps formed by the arms of the insulation regions (304a-308e).

9. The photodiode of one of claims 1 to 8, comprising a contacting conductor connected to the insulation region (20), for reading out a photocurrent generated in a space charge zone region (22) formed by the insulation region (20).

EP 1 508 173 B1

**Revendications**

1. Photodiode, aux caractéristiques suivantes :

un substrat à semi-conducteur (12) ;
une zone photosensible (18 ; 24) dans le substrat, la zone photosensible présentant une zone de charge spatiale (18) destinée à générer une partie de courant de dérive et une zone de diffusion (24) destinée à générer une partie de courant de diffusion ; et
un dispositif d'isolation (20) dans le substrat à semi-conducteur (12) destiné à délimiter au moins partiellement la zone de diffusion (24) d'une zone d'environnement (28) adjacente du substrat à semiconducteurs (12), le substrat à semi-conducteur (12) étant d'un premier type de conduction, et la zone de charge spatiale (18) étant constituée par une zone de signal (16) d'un deuxième type de conductivité dans le substrat à semi-conducteur, lequel est différent du premier type de conductivité,
le dispositif d'isolation étant constitué par une zone d'isolation (20) du deuxième type de conductivité dans le substrat à semi-conducteur (12), à une distance prédéterminée de la zone de signal (16), et le substrat à semi-conducteur (12) présentant un profil de dopage qui présente une densité de dopage diminuant dans la direction de profondeur, de sorte qu'il en résulte un bombage d'une zone de charge spatiale de la zone d'isolation (20) dans des régions du substrat à semi-conducteur (12) situées à une plus grande profondeur, lequel s'étend également sous la zone photosensible (18 ; 24) et isole, de ce fait, cette dernière verticalement de régions du substrat à semi-conducteur (12) situées à une profondeur encore plus grande ou la protège contre les porteuses de charge y générées et se diffusant en direction de la zone photosensible (18 ; 24).

2. Photodiode selon la revendication 1, dans laquelle la zone de signal (16) présente une structure en peigne (310a à 313d).

3. Photodiode selon la revendication 1 ou 2, dans laquelle la distance prédéterminée est plus petite que la longueur de diffusion de porteuses de charge libres dans le substrat à semi-conducteur.

4. Photodiode selon l'une des revendications 1 à 3, dans laquelle la distance prédéterminée se situe dans une plage de 1 μm à 7 μm.

5. Photodiode selon l'une des revendications 1 à 4, dans laquelle la zone d'isolation (20) s'étend jusqu'à une profondeur déterminée dans le substrat (12) qui est d'un multiple prédéterminé supérieure à la profondeur s'étendant à partir de la surface principale (14) du substrat (12) d'une zone de signal (16) constituant la zone de charge spatiale (18).

6. Photodiode selon la revendication 5, dans laquelle le multiple prédéterminé est de 2 à 10.

7. Photodiode selon l'une des revendications 1 à 6, dans lequel la zone d'isolation (20) présente plusieurs bras (304a à 308e) qui sont réalisés orientés éloignés l'un de l'autre en étoile, chaque bras s'étendant entre la zone photosensible et d'autres zones photosensibles adjacentes qui, ensemble avec la zone photosensible, font partie d'une rangée de photodiodes (250).

8. Photodiode selon la revendication 7, dans laquelle le dispositif d'isolation présente d'autres zones d'isolation (304a à 308e) qui constituent, ensemble, également une rangée (200), les zones d'isolation (304a à 308e) et les zones photosensibles étant disposées de sorte que les zones photosensibles soient formées individuellement dans des espaces intermédiaires formés par les bras des zones d'isolation (304a à 308e).

9. Photodiode selon l'une des revendications 1 à 8, présentant un conducteur de contact qui est relié à la zone d'isolation (20), en vue de la lecture d'un courant photoélectrique généré dans une zone de charge spatiale (22) formée par la zone d'isolation (20).

17

# FIG 1

FIG 2A

# FIG 2B

## FIG 3A

## FIG 3B

# FIG 4

EP 1 508 173 B1

## FIG 8

## FIG 5

## FIG 6

## FIG 7

## FIG 9

## FIG 11A

## FIG 10

# FIG 11B

ZEIT IN μs